(19) Europäisches Patentamt
European Patent Office
Office européen des brevets

(11) EP 3 223 299 A1

(12) EUROPEAN PATENT APPLICATION
published in accordance with Art. 153(4) EPC

(43) Date of publication:
27.09.2017 Bulletin 2017/39

(51) Int Cl.:
H01J 37/30 (2006.01)     B22F 3/105 (2006.01)
B22F 3/16 (2006.01)      H01J 37/305 (2006.01)

(21) Application number: 16828909.8

(22) Date of filing: 21.01.2016

(86) International application number:
PCT/JP2016/051656

(87) International publication number:
WO 2017/126073 (27.07.2017 Gazette 2017/30)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(71) Applicant: Technology Research Association for
Future
Additive Manufacturing
Tokyo 103-0027 (JP)

(72) Inventor: GOTO, Kazuya
Akishima-shi, Tokyo 196-8558 (JP)

(74) Representative: TBK
Bavariaring 4-6
80336 München (DE)

(54) 3D-MODELING DEVICE, 3D-MODELING DEVICE CONTROL METHOD AND 3D-MODELING DEVICE CONTROL PROGRAM

(57) Excessive evaporation of powder is prevented. A three-dimensional shaping apparatus includes an electron gun that generates an electron beam; a primary main deflector that deflects the electron beam one- or two-dimensionally; at least one lens that is provided between the electron gun and the primary main deflector and focuses the electron beam; a sub-deflector that is provided between the electron gun and the primary main deflector, deflects the electron beam one- or two-dimensionally, and has a deflection area smaller than the deflection area of the primary main deflector and the scanning speed higher than a scanning speed of the primary main deflector; and a controller that controls deflection directions and the scanning speeds of the primary main deflector and the sub-deflector. The primary main deflector moves the deflection area of the sub-deflector, and the sub-deflector performs multiple scanning and irradiation of small regions, in which scanning and irradiation the small regions are each included in the deflection area and scanned and irradiated with the electron beam for a predetermined number of times.

F I G. 1

EP 3 223 299 A1

**Description**

TECHNICAL FIELD

The present invention relates to a three-dimensional shaping apparatus, a control method of the three-dimensional shaping apparatus, and a control program of the three-dimensional shaping apparatus.

BACKGROUND ART

In the above technical field, patent literature 1 discloses a three-dimensional product manufacturing apparatus that scans powder with an electron beam.

CITATION LIST

PATENT LITERATURE

Patent literature 1: Japanese PCT National Publication No. 2003-531034

SUMMARY OF THE INVENTION

TECHNICAL PROBLEM

In the technique described in the above literature, however, it is impossible to prevent excessive evaporation of the powder.
The present invention enables one to provide a technique of solving the above-described problem.

SOLUTION TO PROBLEM

One aspect of the present invention provides a three-dimensional shaping apparatus comprising:

an electron gun that generates an electron beam;
a primary main deflector that deflects the electron beam one- or two-dimensionally;
at least one lens that is provided between the electron gun and the primary main deflector, and focuses the electron beam;
a sub-deflector that is provided between the electron gun and the primary main deflector, deflects the electron beam one- or two-dimensionally, and has a deflection area smaller than the deflection area of the primary main deflector and a scanning speed higher than the scanning speed of the primary main deflector; and
a controller that controls deflection directions and the scanning speeds of the primary main deflector and the sub-deflector,
wherein the primary main deflector moves the deflection area of the sub-deflector, and
the sub-deflector performs multiple scanning and irradiation of small regions, in which scanning and irradiation the small regions are each included in the deflection area and scanned and irradiated with the electron beam for a predetermined number of times.

Another aspect of the present invention provides a control method of a three-dimensional shaping apparatus including
an electron gun that generates an electron beam;
a primary main deflector that deflects the electron beam one- or two-dimensionally;
at least one lens that is provided between the electron gun and the primary main deflector, and focuses the electron beam;
a sub-deflector that is provided between the electron gun and the primary main deflector, deflects the electron beam one- or two-dimensionally, and has a deflection area smaller than the deflection area of the primary main deflector and a scanning speed higher than the scanning speed of the primary main deflector; and
a controller that controls deflection directions and the scanning speeds of the primary main deflector and the sub-deflector,
the method comprising:

causing the primary main deflector to move the deflection area of the sub-deflector; and
causing the sub-deflector to perform multiple scanning and irradiation of small regions, in which scanning and irradiation the small regions are each included in the deflection area and scanned and irradiated with the electron beam for a predetermined number of times.

Still another aspect of the present invention provides a control program of a three-dimensional shaping apparatus including

an electron gun that generates an electron beam;
a primary main deflector that deflects the electron beam one- or two-dimensionally;
at least one lens that is provided between the electron gun and the primary main deflector, and focuses the electron beam;
a sub-deflector that is provided between the electron gun and the primary main deflector, deflects the electron beam one- or two-dimensionally, and has a deflection area smaller than the deflection area of the primary main deflector and a scanning speed higher than the scanning speed of the primary main deflector; and
a controller that controls deflection directions and the scanning speeds of the primary main deflector and the sub-deflector, the program causing a computer to execute a method comprising:

causing the primary main deflector to move the deflection area of the sub-deflector; and
causing the sub-deflector to perform multiple scanning and irradiation of small regions, in which scanning and irradiation the small regions are each included in the deflection area and scanned and irradiated with the electron beam for a predetermined number of times.

ADVANTAGEOUS EFFECTS OF INVENTION

The present invention prevents excessive evaporation of the powder.

BRIEF DESCRIPTION OF DRAWINGS

Fig. 1 is a view explaining the configuration of a three-dimensional shaping apparatus according to the first embodiment of the present invention;
Fig. 2 is a view explaining how a small region in the sub-deflection field is scanned and irradiated with the electron beam by the three-dimensional shaping apparatus according to the first embodiment of the present invention;
Fig. 3 is a view explaining how small regions to be scanned and irradiated by the three-dimensional shaping apparatus according to the first embodiment of the present invention are arranged on the shaping plane;
Fig. 4 is a view showing a calculation model for calculating the temperature distribution of a powder layer in the depth direction and the time transition of its temperature distribution, which layer is scanned and irradiated by the three-dimensional shaping apparatus according to the first embodiment of the present invention;
Fig. 5 shows graphs each showing the relationship between the temperature of a layered material and the heat given per unit volume to it, which material is scanned and irradiated by the three-dimensional shaping apparatus according to the first embodiment of the present invention;
Fig. 6 is a graph showing the temperature distribution of the layered material at the completion of its irradiation, which material is scanned and irradiated by the three-dimensional shaping apparatus according to the first embodiment of the present invention;
Fig. 7 is a timing chart showing the time transitions of the temperatures of the outermost and deepest parts of the layered material scanned and irradiated (not multiple irradiation) by the three-dimensional shaping apparatus according to the first embodiment of the present invention;
Fig. 8 shows timing charts each showing the time transitions of the temperatures of the outermost and deepest parts of the layered material scanned and irradiated (multiple irradiation) by the three-dimensional shaping apparatus according to the first embodiment of the present invention;
Fig. 9 shows views explaining that a discontinuous plane exists in a layered material to be a part of a three-dimensional structure shaped by the three-dimensional shaping apparatus according to the first embodiment of the present invention;
Fig. 10 shows timing charts explaining the time transitions of the temperatures of the outermost and deepest parts of when the discontinuous plane exists at a given position of the layered material to be a part of the three-dimensional structure shaped by the three-dimensional shaping apparatus according to the first embodiment of the present invention;
Fig. 11A is a flowchart explaining a procedure of shaping a three-dimensional structure with the three-dimensional shaping apparatus according to the first embodiment of the present invention;
Fig. 11B is a flowchart explaining a procedure of the scanning and irradiation with the electron beam in the procedure of shaping a three-dimensional structure with the three-dimensional shaping apparatus according to the first embodiment of the present invention;

Fig. 12A is a view showing the configuration of a three-dimensional shaping apparatus according to the technical premise of the three-dimensional shaping apparatus according to the first embodiment of the present invention;

Fig. 12B is a flowchart explaining a procedure of shaping a three-dimensional structure by the three-dimensional shaping apparatus according to the technical premise of the three-dimensional shaping apparatus according to the first embodiment of the present invention;

Fig. 13 shows views each explaining how small regions in the sub-deflection field are scanned and irradiated with the electron beam by a three-dimensional shaping apparatus according to the second embodiment of the present invention;

Fig. 14 is a view explaining how small regions scanned and irradiated by the three-dimensional shaping apparatus are arranged on the shaping plane according to the second embodiment of the present invention; and

Fig. 15 is a view for explaining another configuration of the three-dimensional shaping apparatus according to the second embodiment of the present invention.

DESCRIPTION OF THE EMBODIMENTS

Preferred embodiments of the present invention will now be described in detail with reference to the drawings. It should be noted that the relative arrangement of the components, the numerical expressions and numerical values set forth in these embodiments do not limit the scope of the present invention unless stated otherwise specifically.

[First Embodiment]

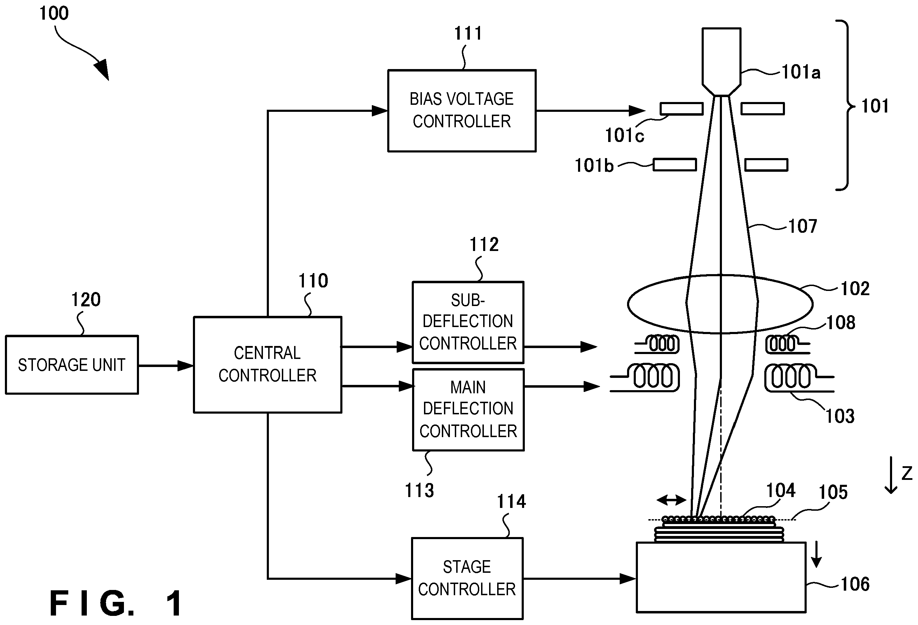

A three-dimensional shaping apparatus 100 according to the first embodiment of the present invention will be described with reference to Figs. 1A to 12B.

<Technical Premise>

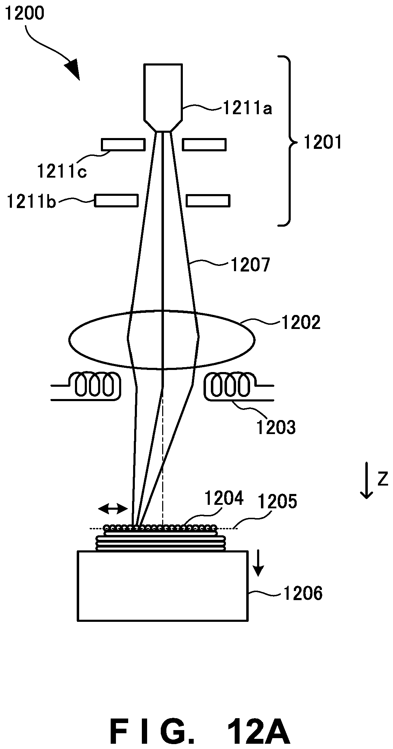

The technical premise of this embodiment will be described first. Fig. 12A is a view explaining the configuration of a three-dimensional shaping apparatus 1200 according to the technical premise of the three-dimensional shaping apparatus 100 according to this embodiment. The three-dimensional shaping apparatus 1200 is an electron beam three-dimensional shaping apparatus, which shapes three-dimensional structures using an electron beam. The three-dimensional shaping apparatus 1200 shapes desired three-dimensional structures by melting and solidifying metal powder 1204 by the focused electron beam 1207, and sequentially laminating the metal powder.

As shown in Fig. 12A, the three-dimensional shaping apparatus 1200 includes an electron gun 1201, a lens 1202, and a deflector 1203. The electron gun 1201 is a thermoelectron emission electron gun, the lens 1202 is an electromagnetic lens, and the deflector 1203 is an electromagnetic deflector. The deflector 1203 consists of X-direction deflection coils and Y-direction deflection coils. The three-dimensional shaping apparatus 1200 further includes a mechanism (not shown) for spreading the metal powder 1204 over the shaping plane 1205, and a Z-axis stage 1206 for setting the height position of the metal powder 1204 at the height of the shaping plane 1205.

Under the above configuration, first, the three-dimensional shaping apparatus 1200 spreads the metal powder 1204 over the shaping plane 1205. That is, the three-dimensional shaping apparatus 1200 forms a powder layer consisting of the metal powder 1204. The particle size (diameter) of the metal powder 1204 is mostly several tens of microns.

Second, the three-dimensional shaping apparatus 1200 causes the electron gun 1201 to generate the electron beam 1207, causes the lens 1202 to focus the electron beam 1207 so that the cross-sectional diameter of the electron beam 1207 becomes smallest on the shaping plane 1205, and causes the deflector 1203 to deflect the electron beam 1207 in two-dimensional (X and Y) directions, thereby scanning and irradiating the predetermined regions on the shaping plane 1205 with the electron beam 1207. That is, the metal powder 1204 in the region is heated. More specifically, the metal powder 1204 in the region is preheated (preliminarily sintered), and then melted. Here, the deflector 1203 is controlled based on data representing the shape of the desired three-dimensional structure (shape data) and data representing shaping conditions (shaping condition data). The steps of preheating and melting the metal powder 1204 will hereinafter be referred to simply as the preheating and melting steps, respectively.

The metal powder 1204 melted in the preheating and melting steps then is solidified and forms a thin metal layer as part of a desired three-dimensional structure. The metal layer is no longer a powder layer but is a continuous structure. Therefore, the desired three-dimensional structure is shaped by repeating the above steps of laminating such layers. Note here that this requires one to, before newly spreading the metal powder 1204 over the metal layer, compensate for the height of the structure in process by the thickness of the metal layer.

Third, the three-dimensional shaping apparatus 1200, for the above requirement, moves the Z-axis stage 1206 by the thickness of the metal layer. The thickness, that is, the moving step of the Z-axis stage 1206, in typical electron beam three-dimensional shaping apparatuses is about 100 $\mu$m. Therefore, the thickness of the powder layer consisting of the metal powder 1204 spread over the shaping plane 1205 also is about 100 $\mu$m. The movable range of the Z-axis stage 1206, that is, the maximum shaping depth is several hundreds of millimeters.

The most important performance indices of the three-dimensional shaping apparatus 1200 include the shaping resolution and the shaping speed. The shaping resolution of the three-dimensional shaping apparatus 1200 is determined by the cross-sectional diameter of the electron beam 1207 on the shaping plane 1205. The shaping speed of the three-dimensional shaping apparatus 1200 is, regardless of the cross-sectional diameter of the electron beam 1207, proportional to the power of the electron beam 1207. Note that the shaping speed mentioned here does not take account of the operation of the Z-axis stage 1206.

The reasons why the shaping speed of the three-dimensional shaping apparatus 1200 is proportional to the power of the electron beam 1207 are as follows. First, the volume [cm$^3$] of a structure shaped by the three-dimensional shaping apparatus 1200 is proportional to the heat [J] given by the electron beam 1207 to the structure. Second, the shaping speed [cm$^3$/s] (or [cm$^3$/h]) of the three-dimensional shaping apparatus 1200 is the time derivative of the volume of the structure. Third, the power [W] of the electron beam 1207 is the time derivative of the heat given to the structure. Here, the first reason assumes that the heat given per unit area by the electron beam 1207 to the metal powder 1204 is uniform, and the third reason assumes that the power of the electron beam 1207 is supplied to the metal powder 1204 without loss. These assumptions are also applied to the following descriptions.

Since the shaping speed of the three-dimensional shaping apparatus 1200 is proportional to the power of the electron beam 1207 as described above, one can increase the shaping speed by increasing the power of the electron beam 1207. However, this requires one to simultaneously increase the speed of the scan with the electron beam 1207. This is because, first, the volume is proportional to the distance of the scanning with the electron beam 1207 and, second, the time derivative of the distance is the speed of the scanning with the electron beam 1207.

The power of the electron beam 1207 is the multiplication product of the acceleration voltage and the current of the electron beam 1207. The acceleration voltage of the electron beam 1207 is the voltage between the cathode 1211a and the anode 1211b in Fig. 12A. The acceleration voltage of the electron beam in typical electron beam three-dimensional shaping apparatuses is several tens of killovolts.

A general way to increase the power of the electron beam 1207 is by increasing the current of the electron beam 1207. The current of the electron beam 1207 is controlled by adjusting the bias voltage of the electron gun 1201. The bias voltage is a voltage between the cathode 1211a and the grid 1211c in Fig. 12A.

The current of the electron beam 1207 may contrarily be set small. This applies to a case in which the shaping resolution is prioritized over the shaping speed. That is, the cross-sectional diameter of the electron beam 1207 is decreased by decreasing the current of the electron beam 1207. This is because the aperture angle of the electron beam 1207 on the shaping plane 1205 decreases along with a decrease in the current of the electron beam 1207, resulting in small aberrations caused by the lens 1202. Note here that even when a high shaping resolution is required, a higher shaping speed is preferred, and thus a higher current of the electron beam 1207 is ideal.

The control of the current by the bias voltage is also performed to completely shut off the electron beam 1207 and thereby set its current to zero. The process steps in which the current of the electron beam 1207 is set to zero, that is, the process steps in which the electron beam 1207 is unnecessary, include the step of spreading the metal powder 1204 over the shaping plane 1205 and the step of moving the Z-axis stage 1206.

The shaping speed of the three-dimensional shaping apparatus 1200 being high, that is, the power of the electron beam 1207 being high and the speed of the scanning with the electron beam 1207 also being high, means that the time during which each point in the region scanned with the electron beam 1207 is irradiated is short. The time mentioned here is the quotient of the cross-sectional diameter of the electron beam 1207 divided by the speed of the scanning with the electron beam 1207, and is also the quotient of the heat given per unit area to the metal powder 1204 divided by the power of the electron beam 1207 per unit area. That is, the time during which each point in the region scanned with the electron beam 1207 is irradiated is inversely proportional to the speed of the scanning with the electron beam 1207 and is proportional to the heat given per unit area to the metal powder 1204.

The above heat per unit area is, in the preheating step, heat required per unit area to raise the temperature of the metal powder 1204 from an initial temperature to a preheating temperature, and is also, in the melting step, the sum of heat required per unit area to raise the temperature of the metal powder 1204 from the preheating temperature to a target temperature and heat required per unit area to melt the metal powder 1204. Here, melting of the metal powder 1204 refers to that the metal powder 1204 melts as a result of its absorbing the melting heat (latent heat) at its melting point.

The above power per unit area is also the quotient of the power of the electron beam 1207 divided by the cross-sectional area of the electron beam 1207. Therefore, the power per unit area increases when the power of the electron beam 1207 is increased to increase the shaping speed, when the cross-sectional diameter of the electron beam 1207 is decreased to increase the shaping resolution, or when the power of the electron beam 1207 is increased and the cross-sectional diameter of the electron beam 1207 is decreased to increase both the shaping speed and the shaping resolution.

Added to the above explanations is that, from the inversely and directly proportional relationships mentioned above, the heat given per unit area by the electron beam 1207 to the metal powder 1204 increases or decreases depending on the speed of the scanning with the electron beam 1207. Therefore, whether or not to melt the metal powder 1204 can be controlled by the scanning speed. That is, the metal powder 1204 melts when the scanning speed is decreased, but does not melt when the scanning speed is increased.

The above fact is an advantage in the melting step. This is because the scans of regions where the metal powder 1204 is melted include, unless the entire scan of the regions to be scanned altogether can be a single continuous scan, scans of regions where the metal powder 1204 is not melted. That is, in the melting step, the metal powder 1204 in the region where the metal powder 1204 is not supposed to be melted can be given nonzero heat per unit area, which heat can lead to unnecessary melting of the metal powder 1204, but such unnecessary melting can be prevented by setting the scanning speed for the region where the metal powder 1204 is not supposed to be melted to be higher than that for the region where the metal powder 1204 is melted.

The unnecessary melting can be theoretically prevented by the current control of the electron beam 1207, which control is by changing the bias voltage, or by blanking of the electron beam 1207. However, such control is difficult in most cases. The reason why the current control of the electron beam 1207 by changing the bias voltage is difficult is that it is difficult to change the bias voltage at a high speed because the bias voltage is generally as high as several kilovolts. If it takes a long time to change the current for the above reason, the shaping speed decreases. Compared with the change in the current, the change in the scanning speed can be made extremely fast. The reason why the blanking of the electron beam 1207 is difficult is that the current of the electron beam 1207 is high enough to melt metal objects, and thus deflecting the electron beam 1207, even if temporarily, to make it incident on a shielding plate (metal) or the like can cause thermal damage to it and its surroundings.

The preheating and melting of the powder layer consisting of the metal powder 1204 are not completed only by scanning and irradiating the powder layer with the electron beam 1207. More specifically, the preheating and melting of the powder layer require that heat given by the scanning and irradiation of the powder layer to the heat generating part (superficial part) of the powder layer be diffused to a deeper part of the powder layer. This is because in most cases the thickness of the heat generating part is smaller than that of the powder layer. The thickness of the heat generating part is several microns to several tens of microns when the acceleration voltage of the electron beam 1207 is several tens of kilovolts. In contrast, the thickness of the powder layer is about 100 $\mu$m, as described above.

The preheating and melting of the powder layer requiring the thermal diffusion can prevent one from increasing the power of the electron beam 1207 per unit area to improve the shaping speed, resolution, or both of the three-dimensional shaping apparatus 1200. This depends on the relationship between the time during which each point scanned with the electron beam 1207 is irradiated and the time taken for the thermal diffusion. If the former time is shorter than the latter time, that is, if the power of the electron beam 1207 per unit area is accordingly increased, the heat given to the superficial part of the powder layer can, without waiting for the thermal diffusion, melt and evaporate only the superficial part and its vicinity.

The metal powder 1204 can evaporate regardless of whether or not its temperature exceeds its melting point. More specifically, the evaporation amount increases exponentially with respect to rising temperature. The evaporation cannot be avoided as long as the metal powder 1204 is heated. If the evaporation amount is excessive, the following problems become conspicuous.

First, the thickness of the metal layer formed by the melting and solidification of the metal powder 1204 decreases. Second, an evaporated metal film is formed on the inner wall of the three-dimensional shaping apparatus 1200, and thus its inside becomes contaminated. The increase in the thickness of the film increases the ease with which it flakes off, and when it flakes off, it prevents the metal powder 1204 beneath it from being irradiated and heated as expected. Third, along with the evaporation of the superficial part of the powder layer, the heat that should have been given to the layer thickness of from the outermost to the deepest part of the power layer is dissipated outward, and thus a deeper part of the power layer cannot be given the heat necessary for its melting. If the deeper part of the powder layer is not melted, it becomes impossible to form a structure continuous in the depth direction (Z direction). If, as a solution to the above problem, the power of the electron beam 1207 per unit area is increased to give sufficient heat to the deeper part of the powder layer, the temperature of the superficial part of the powder layer rises even further, which consequently accelerates the evaporation.

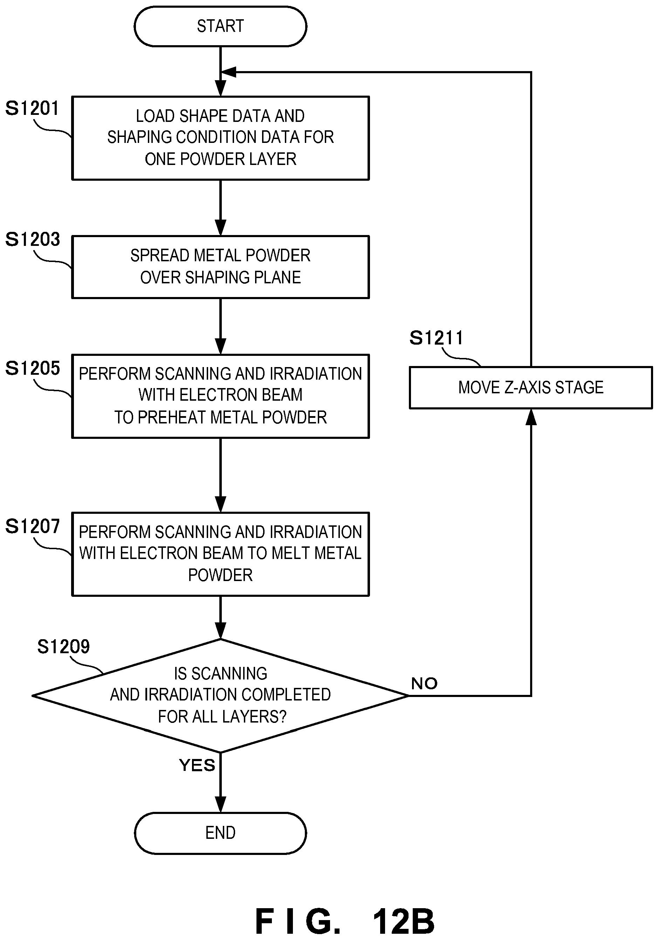

A procedure of shaping a three-dimensional structure by the three-dimensional shaping apparatus 1200 will be described with reference to Fig. 12B. Fig. 12B is a flowchart explaining the procedure of shaping a three-dimensional structure with the three-dimensional shaping apparatus 1200.

In step S1201, the three-dimensional shaping apparatus 1200 loads the shape data and shaping condition data for one powder layer. In step S1203, the three-dimensional shaping apparatus 1200 spreads the metal powder 1204 over the shaping plane 1205, thereby forming a powder layer consisting of the metal powder 1204. In step S1205, to preheat the metal powder 1204 in a predetermined region (or the entire region) on the shaping plane 1205, the three-dimensional shaping apparatus 1200 scans and irradiates the region by causing the main deflector 1203 to deflect the electron beam 1207. In step S1207, to melt the metal powder 1204 in the predetermined region, the three-dimensional shaping apparatus 1200 scans and irradiates the predetermined region by causing the main deflector 1203 to deflect the electron beam 1207. In step S1209, the three-dimensional shaping apparatus 1200 judges whether or not the scanning and irradiation has been completed for all layers. If the judgment is that the scanning and irradiation has been completed (YES in step S1209), the three-dimensional shaping apparatus 1200 ends shaping; otherwise (NO in step S1209), the three-dimensional shaping apparatus 1200 advances to step S 1211. In step S 1211, the three-dimensional shaping apparatus 1200 moves the Z-axis stage 1206 by the thickness of the metal layer formed in the above steps. The three-dimensional shaping apparatus 1200 repeats step S1201 and the subsequent steps.

<Technique of Embodiment>

Fig. 1 is a view explaining the configuration of the three-dimensional shaping apparatus 100 according to this embodiment. The three-dimensional shaping apparatus 100 basically has the same configuration as that of the three-dimensional shaping apparatus 1200 shown in Fig. 12A. That is, as shown in Fig. 1, the three-dimensional shaping apparatus 100 includes an electron gun 101, a lens 102, a deflector 103, and a Z-axis stage 106. The deflection area, that is, the shaping area of the main deflector 103 of the three-dimensional shaping apparatus 100, is a 200-mm square. The movable range of the Z-axis stage 106 of the three-dimensional shaping apparatus 100, that is, the maximum shaping depth, is 200 mm.

The configuration of the three-dimensional shaping apparatus 100 is different from that of the three-dimensional shaping apparatus 1200 shown in Fig. 1 in that the former, unlike the latter, includes a sub-deflector 108 as a deflector in addition to the main deflector 103. As with the main deflector 103, the sub-deflector 108 consists of X-direction deflection coils and Y-direction deflection coils. The deflection area of the sub-deflector 108 is square and has a size of 4 mm square, which is much smaller than the size of the deflection area of the main deflector 103. The reason why the deflection area of the sub-deflector 108 is as small as described above is that the number of turns for the coils forming the sub-deflector 108 is smaller than that for the coils forming the main deflector 103. The deflection area of the sub-deflector 108 will hereinafter be referred to as the sub-deflection field.

The following describes the control system of the three-dimensional shaping apparatus 100. The three-dimensional shaping apparatus 100 includes, as components of the control system, a central controller 110, a bias voltage controller 111, a sub-deflection controller 112, a main deflection controller 113, a stage controller 114, and a storage unit 120.

The bias voltage controller 111 is connected to the grid 101c, the sub-deflection controller 112 is connected to the sub-deflector 108, the main deflection controller 113 is connected to the main deflector 103, and the stage controller 114 is connected to the Z-axis stage 106. The bias voltage controller 111, sub-deflection controller 112, main deflection controller 113, and stage controller 114 each are also connected to the central controller 110. The central controller 110 is connected to the storage unit 120. The storage unit 120 stores shape data and shaping condition data.

The following describes the operation of the three-dimensional shaping apparatus 100 in further detail. The operation of the three-dimensional shaping apparatus 100 is basically the same as that of the three-dimensional shaping apparatus 1200 shown in Fig. 12A. That is, as with the three-dimensional shaping apparatus 1200 shown in Fig. 12A, the three-dimensional shaping apparatus 100 spreads metal powder 104 over the shaping plane 105, thereby forming a powder layer consisting of the metal powder 104. The three-dimensional shaping apparatus 100 causes the electron gun 101 to generate an electron beam 107, causes the lens 102 to focus the electron beam 107, causes the main deflector 103 to deflect the electron beam 107, and scans and irradiates the metal powder 104 with the electron beam 107, thereby preheating (preliminarily sintering) the metal powder 104, and melting and solidifying the metal powder 104. The three-dimensional shaping apparatus 100 uses the Z-axis stage 106 to compensate for an increase in the height of a three-dimensional structure in process, which increase results from the melting and solidification of the metal powder 104.

However, the operation of the three-dimensional shaping apparatus 100 is different from that of the three-dimensional shaping apparatus 1200 shown in Fig. 12A in that unlike the latter the former uses, in the melting step, the sub-deflector 108 in addition to the main deflector 103 to scan and irradiate the metal powder 104, and performs, in the melting step, multiple scanning and irradiation of regions where the metal powder 104 is melted. The three-dimensional shaping apparatus 100 uses the sub-deflector 108 to scan not only the regions where the metal powder 104 is melted but also the regions where the metal powder 104 is not melted, the scanning of the latter regions preventing unnecessary melting of the metal powder 104 in them.

The reason why the three-dimensional shaping apparatus 100 uses the sub-deflector 108 to scan and irradiate the metal powder 104 in the melting step is to increase, in the melting step, the scanning speed of when performing multiple scanning and irradiation of the regions where the metal powder 104 is melted and the scanning speed of when scanning, while preventing the unnecessary melting, the regions where the metal powder 104 is not melted. That is, the scanning speed of the sub-deflector 108 is higher than that of the main deflector 103. This is ensured by the response speed of the sub-deflector 108 and sub-deflection controller 112 being higher than that of the main deflector 103 and main deflection controller 113. The high response speed stems from the fact that the number of turns for the coils forming the sub-deflector 108 is smaller than that of the coils forming the main deflector 103, that is, the fact that the inductance of the former is smaller than that of the latter.

The reason why the three-dimensional shaping apparatus 100 performs, in the melting step, multiple, not single, scanning and irradiation of the regions where the metal powder 104 is melted is to, in the melting step, reduce the heat given per unit area to the powder layer consisting of the metal powder 104, and diffuse the heat given to the heat generating part (superficial part) to a deeper part of the powder layer gradually. This can prevent the excessive temperature rise of the metal powder 104, thereby preventing excessive evaporation of the metal powder 104. Note that implementing this makes it necessary to increase the scanning speed for the region. That is, the high-speed response of the sub-deflector 108 and sub-deflection controller 112 is an advantage for the scanning.

The operations of the controllers 110, 111, 112, 113, and 114 of the three-dimensional shaping apparatus 100 are as follows. The data stored in the storage unit 120 is input to the central controller 110. Based on the data, the central controller 110 controls the bias voltage controller 111, main deflection controller 113, sub-deflection controller 112, and stage controller 114. More specifically, the central controller 110 increases or decreases the current of the electron beam 107 by changing the bias voltage via the bias voltage controller 111, operates the main deflector 103 via the main deflection controller 113, and operates the sub-deflector 108 via the sub-deflection controller 112, and moves the Z-axis stage 106 by a necessary moving step via the stage controller 114.

The storage unit 120 stores the following as shaping conditions: the acceleration voltage and current of the electron beam 107, the density [g/cm$^3$], specific heat [J/(g·K)], heat conductivity [W/(cm·K)], melting heat [J/g], room temperature [°C], preheating temperature [°C], and target temperature [°C] of the metal powder 104, and the thickness [μm] of the powder layer consisting of the metal powder 104, as well as the degree of multiplication of the scanning and irradiation, that is, the repetition number of the scanning.

Out of the above shaping conditions, the room temperature, preheating temperature, and target temperature determine the temperature rises of the powder layer consisting of the metal powder 104 in the preheating and melting steps, and the room temperature, preheating temperature, target temperature, and the density, specific heat, and melting heat of the metal powder 104 determine the heats to be given per unit volume [J/cm$^3$] to the powder layer in the preheating and melting steps. The above temperature rises and heats per unit volume are those of when the temperature distribution of the powder layer consisting of the metal powder 104 in the depth direction (Z direction) is leveled. Multiplying the heats per unit volume by the thickness of the powder layer consisting of the metal powder 104 gives the heats given per unit area [J/cm$^2$] to the powder layer in the preheating and melting steps. Dividing the heats per unit area by the power of the electron beam 107 per unit area [W/cm$^2$] gives the times [t] during which each point in the regions where the metal powder 104 is melted is irradiated in the preheating and melting steps, and dividing the times by the repetition number of the scanning gives the irradiation time [t] per irradiation for each point. The above power of the electron beam 107 per unit area is determined by the acceleration voltage, current, and cross-sectional diameter of the electron beam 107. Further dividing the distance between two adjacent points in the region by the irradiation time per irradiation gives the speed of the scanning of the region with the electron beam 107. These calculations are performed by the central controller 110.

The melting step according to this embodiment will be described in detail below. The preheating step according to this embodiment is the same as that in conventional techniques and a description thereof will be omitted.

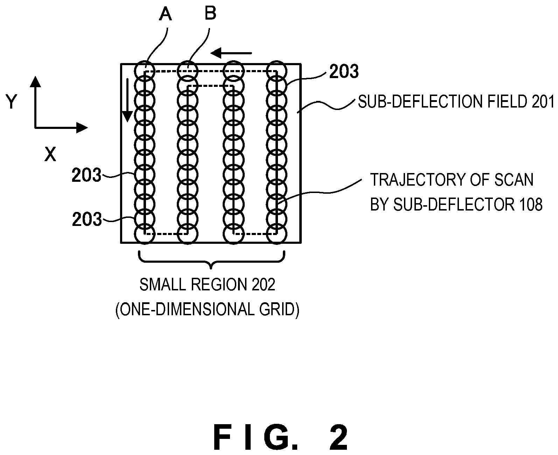

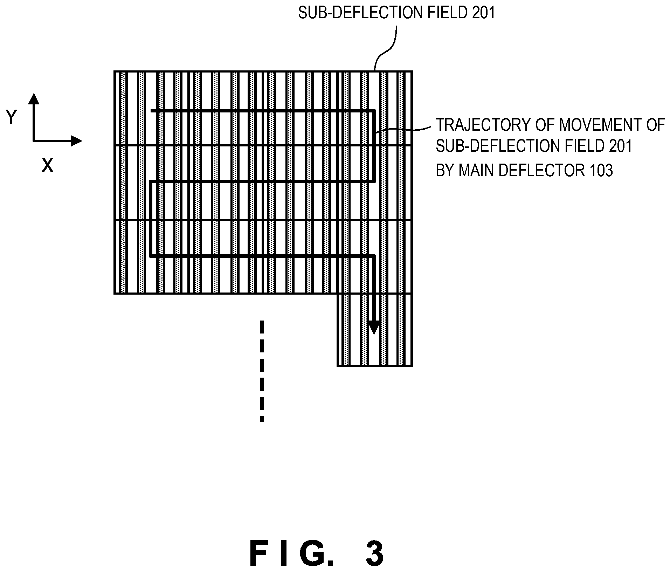

Fig. 2 is a view explaining how a small region in the sub-deflection field is scanned and irradiated with the electron beam by the three-dimensional shaping apparatus according to this embodiment. Fig. 3 is a view explaining how small regions to be scanned and irradiated by the three-dimensional shaping apparatus according to this embodiment are arranged on the shaping plane. The small region shown in Fig. 2 is identical to each of the small regions shown in Fig. 3.

The scanning and irradiation is performed by dividing the region where the metal powder 104 is melted into small regions 202 each of which can be included in the deflection field of the sub-deflector 108, that is, the sub-deflection field 201, causing the sub-deflector 108 to perform multiple scanning of each small region 202, and causing the main deflector 103 to shift the sub-deflection field every time the scanning of one small region 202 is completed. By repeating the above series of processes, the small regions 202 completed with the multiple scanning and irradiation by the sub-deflector 108 are arranged successively on the shaping plane 105 and the regions where the metal powder 104 is melted are filled with the small regions. Here, the completion of the scanning of one small region 202 refers to that as a result of the multiple scanning and irradiation of the small region 202, all points in it are given heat necessary to melt the metal powder 104.

Added to the above explanations is that if the region where the metal powder 104 is melted is small, and can thus be included in the sub-deflection field 201, the region need not be divided into smaller regions. In that case, the region can be processed as one small region 202.

As shown in Figs. 2 and 3, the small regions 202 included in the sub-deflection field 201 in this embodiment each form a one-dimensional grid. The one-dimensional grid is a division of a one-dimensional grid larger than the sub-deflection field 201, which grid is divided into grids each having a size equal to that of the sub-deflection field 201. Note that when a plurality of the one-dimensional grids are laminated, their directions are rotated by 90° one layer after another. This connects X-direction one-dimensional grids and Y-direction one-dimensional grids in the Z direction, thereby forming one continuous, self-standing structure.

In Fig. 2, the trajectories indicated by the solid and the dotted lines are those of the scanning by the sub-deflector 108 in the region where the metal powder 104 is melted (small region 202) and the region where the metal powder 104 is not melted, respectively. Each circle 203 on the trajectory indicated by the solid lines is a circle centered at each point irradiated with the electron beam 107, and represents the cross section of the electron beam 107. That is, each circle 203 is the smallest component of the small region 202.

The start and the end point of the scanning (one separate scanning) of the small region 202 are points A and B in Fig. 2, respectively. The scanning starts at point A. When the scanning operation reaches point B, the same scanning starts again from point A unless the repetition number of the scanning reaches a predetermined number.

Throughout the scanning and irradiation, the electron beam 107 irradiates somewhere in the small region 202, but none of the points in it is irradiated continuously with the electron beam 107. More specifically, any arbitrary point is given a very short time of irradiation periodically. That is, the nth irradiation of any arbitrary point starts after a predetermined waiting time after the (n-1)th irradiation of that point is completed, where n is a natural number which can take all integer values equal to or larger than 2.

During the waiting time, among all the points in the small region 202, the points other than the above arbitrary point are scanned and irradiated. More specifically, assuming that the arbitrary point is a point given the mth irradiation among all the points in the small region 202, the other points in the small region 202, during the waiting time, are irradiated in the following manner: the points given the (m+1)th, (m+2)th,..., Mth irradiation in the sub-deflection field 201 are each given the (n-1)th round of irradiation, and the points given the first, second,..., (m-1)th irradiation in the sub-deflection field 201 are each given the nth round of irradiation. That is, during the waiting time, the (M-1) points in total are irradiated. Note that m is a natural number which can take all integer values equal to or larger than 1, and that M is the maximum value of m, and represents the total number of points in the small region 202. That is, during the waiting time, the three-dimensional shaping apparatus 100 does not wait still but scans the region where the metal powder 104 is melted, and advances the melting of the metal powder 104 in the region.

Let $t_w$ be the waiting time, and $t_e$ be an irradiation time necessary to melt the metal powder 104 at the arbitrary point. Then $t_w$ is given by:

$$t_w = (t_e/N)(M-1) + t_s \qquad (1)$$

where N ($\geq 2$) is the maximum value of n, and represents the total repetition number of the scanning, that is, the number of division of the irradiation time at each point in the small region 202, and $t_s$ represents the time which is included in the waiting time $t_w$ and which is taken to scan the region which is included in the sub-deflection field 201 and where the metal powder 104 is not melted. Meanwhile, the time which is included in the waiting time $t_w$ and which is taken to scan and irradiate the region which is included in the sub-deflection field 201 and where the metal powder 104 is melted is represented by the first term on the right-hand side of equation (1), that is, $(t_e/N)(M-1)$. This is the sum of the irradiation time per irradiation of the arbitrary point, that is, $t_e/N$, over the (M-1) points in total.

The waiting time $t_w$ is set to a value equal to or longer than a predetermined time based on the thickness and thermal diffusion coefficient of the powder layer consisting of the metal powder 104. That is, let $t_d$ be the predetermined time, and then the relationship between $t_d$ and $t_w$ is defined as:

$$t_w \geqq t_d \qquad (2)$$

Equation (1) and inequality (2) give a relationship of:

$$(t_e/N)(M-1) + t_s \geqq t_d \qquad (3)$$

The predetermined time $t_d$ will be described later.

Mathematically, while ensuring that the number of division N of the irradiation time is equal to or larger than a necessary value, one can satisfy inequality (3) by increasing $t_s$ or M. Technically, however, M needs to be increased without increasing $t_s$. This is because $t_s$ is determined automatically by the shapes and dimensions of the small region 202 and because $t_s$ is overhead time, which does not contribute to shaping, and thus is preferably shorter.

By selecting N and M to be such that they satisfy inequality (3), one can, in the above operation, prevent the excessive temperature rise of the metal powder 104 in the small region 202 and thus prevent the excessive evaporation of the metal powder 104. Here, even during the waiting time from when the (n-1)th irradiation of the arbitrary point ends to when the nth irradiation of that point starts, the irradiation, the (n-1)th or nth, of the other points progresses, and thus no overhead time is generated. That is, the shaping speed does not deteriorate.

Added to the above explanations is that just determining the speed at which the sub-deflector 108 scans the small region 202 based on the irradiation time $t_e$ for each point in the small region 202 and scanning the small region 202 at that speed may, because of the slow response of the main deflector 103 and main deflection controller 113, result in a shortage of the heat given per unit area to the small region 202. This is because if the scanning by the sub-deflector 108 starts before the shift of the sub-deflection field 201 by the main deflector 103 has been settled sufficiently, small regions other than the small region 202 or part of them are scanned and irradiated consequently, and thus the time during which the small region 202 is scanned and irradiated decreases accordingly. A similar shortage of the heat per unit area may also result from the slow response of the sub-deflector 108 and sub-deflection controller 112.

If there is such a shortage as described above of the heat given per unit area to the small region 202, the result may be that the superficial part of the powder layer in the small region 202 is melted but a deeper part remains unmelted. This can be coped with by giving a margin to the target temperature or the irradiation time $t_e$, as will be described later.

The predetermined time $t_d$ is given by:

$$t_d = L^2 / (\pi^2 \alpha) \qquad (4)$$

where L represents the thickness of the powder layer consisting of the metal powder 104, and $\alpha$ represents the thermal diffusion coefficient. The thermal diffusion coefficient $\alpha$ is given by:

$$\alpha = \lambda / (\rho c) \qquad (5)$$

where $\lambda$ represents the heat conductivity, $\rho$ represents the density, and c represents the specific heat.

The predetermined time $t_d$ can be derived from the following equation:

$$\frac{\partial T(z,t)}{\partial t} = \alpha \frac{\partial^2 T(z,t)}{\partial z^2}$$

where T represents the temperature at depth z and time t. This equation describes the thermal diffusion in the powder layer of when an arbitrary round of irradiation with the electron beam 107 has been completed. The solution to this equation is written by:

$$T(z,t) = \sum_{k=0}^{\infty} a_k \cos(\frac{k\pi}{L} z) \exp\left\{-\frac{k^2 \pi^2 \alpha}{L^2}(t - t_a)\right\}$$

$$= a_0 + a_1 \cos(\frac{\pi}{L} z) \exp\left\{-\frac{\pi^2 \alpha}{L^2}(t - t_a)\right\} + \sum_{k=2}^{\infty} a_k \cos(\frac{k\pi}{L} z) \exp\left\{-\frac{k^2 \pi^2 \alpha}{L^2}(t - t_a)\right\}$$

$$= a_0 + a_1 \cos(\frac{\pi}{L} z) \exp\left\{-(t - t_a)/\tau_1\right\} + \sum_{k=2}^{\infty} a_k \cos(\frac{k\pi}{L} z) \exp\left\{-(t - t_a)/\tau_k\right\} \qquad (6)$$

the time constant $\tau_1 = L^2/(\pi^2\alpha)$ of the second term on the right-hand side being equal to the predetermined time $t_d$. That is, the second term on the right-hand side of equation (6) is at time $t = t_a$ equal to $a_1\cos(\pi z/L)$, and at time $t = t_a + t_d$ attenuates to $e^{-1}$ times the value (e being the base of the natural logarithm), where $t_a$ represents the end time of the arbitrary round of irradiation. Note that T(z, t) is a solution under the condition that the outermost and deepest parts of the powder layer are thermally insulated, that is, under the condition that the temperature gradient $\partial T(z, t)/\partial z$ is zero at the outermost and deepest parts of the powder layer, and represents, for the sake of convenience, a temperature change of the powder layer as a result of an arbitrary round of irradiation. That is, without the arbitrary round of irradiation, $T(z, t)$ is zero.

The first term on the right-hand side of equation (6) is the zeroth-order component of $T(z, t)$, which component is written as:

$$T_0(z, t) = a_0 \qquad (7)$$

When the thickness of the heat generating part of the powder layer and the temperature rise caused by the arbitrary round of irradiation are represented by h and $T_a$, respectively, that is, when $T(z, t_a)$ is a function which yields $T_a$ in the range of $0 \le z \le h$, and zero in the range of $h < z \le L$, the constant $a_0$ on the right-hand side of equation (7) is given by:

$$a_0 = T_a h / L \qquad (8)$$

Equation (8) is derived from the integrals of the left- and right-hand sides of equation (6) over the range of $0 \le z \le L$ for $t = t_a$, which respectively yield the following relationships:

$$\int_0^L T(z, t_a)\, dz = T_a h$$

$$\int_0^L a_0\, dz = a_0 L$$

The second term on the right-hand side of equation (6) is the first-order component of $T(z, t)$, which is written as:

$$T_1(z, t) = a_1 \cos\left(\frac{\pi}{L} z\right) \exp\left\{-(t - t_a)/\tau_1\right\} \qquad (9)$$

If $h \ll L$, the coefficient $a_1$ on the right-hand side of equation (9) is given by:

$$a_1 \approx 2T_a h/L \qquad (10)$$

Equation (10) is derived from the integrals of the left- and right-hand sides of equation (6) each multiplied by $\cos(\pi z/L)$ over the range of $0 \le z \le L$ for $t = t_a$, which respectively yield the following relationships:

$$\int_0^L T(z, t_a) \cos\left(\frac{\pi}{L} z\right) dz \approx T_a h$$

$$\int_0^L a_1 \cos^2\left(\frac{\pi}{L} z\right) dz = a_1 L / 2$$

Note that here,

$$\cos(\pi z/L) \approx 1$$

is used, which holds in the range of $0 \le z \le h$ if $h \ll L$.

The third term of equation (6) is the total sum of the second- and higher-order components of $T(z, t)$. Descriptions of the coefficients of these components will be omitted for brevity.

Among these components, the zeroth-order component $T_0(z, t)$ (= $a_0$) is the convergence value of $T(z, t)$, and is necessary to melt the powder layer. On the other hand, the other components, that is, the first-order component $T_1(z, t)$ and the second- and higher-order components, attenuate with time, and are not necessary to melt the powder layer. Therefore, the heat given to the heat generating part of the powder layer being sufficiently diffused to a deeper part of the powder layer, that is, $T(z, t)$ sufficiently approaching $a_0$, corresponds to the first- and higher-order components of $T(z, t)$ becoming sufficiently small with time, as compared with the zeroth-order component $T_0(z, t)$ of $T(z, t)$.

The second- and higher-order components of $T(z, t)$ attenuate more quickly than the first-order component $T_1(z, t)$. This is because the time constant $\tau_k = L^2/(k^2\pi^2\alpha)$ of the kth-order component of $T(z, t)$ is inversely proportional to $k^2$, as is found from equation (6). Hence, if an arbitrary round of irradiation with the electron beam 107 has been completed and followed by enough time, and thus the first-order component $T_1(z, t)$ has attenuated sufficiently, the second- and higher-order components of $T(z, t)$ also have attenuated sufficiently. That is, $T(z, t)$ is sufficiently close to the first term $a_0$ on the right-hand side of equation (6).

Whether the first-order component $T_1(z, t)$ has sufficiently attenuated at an arbitrary time can be judged from whether $|T_1(z, t)|$ at the depth position z = 0 or L, that is, $|T_1(0, t)|$ or $|T_1(L, t)|$, has become sufficiently small with respect to $|T_0(z, t)| = a_0$. This is based on the fact that $|T_1(0, t)|$ and $|T_1(L, t)|$ are the maximum values of $|T_1(z, t)|$, that is,

$$|T_1(z, t)| \le |T_1(0, t)| = |T_1(L, t)| \qquad (11)$$

Inequality (11) is based on the fact that not only the first-order component of but also all the other components of $T(z, t)$, that is, $T_k(z, t)$ for $k \ge 0$, satisfy $\partial T_k(z, t)/\partial z = 0$ for z = 0 and L, as is found from equation (6). The following discussion takes account of the magnitude of $T_1(0, t)$ (> 0) with respect to that of $T_0(0, t)$ (= $a_0$ > 0).

From equations (7) to (10), it follows that at time $t = t_a + t_d$, $T_0(0, t)$ and $T_1(0, t)$ respectively become $T_0(0, t_a+t_d)$ = $T_a h/L$ and $T_1(0, t_a + t_d) \approx (2T_a h/L)e^{-1}$. Then the ratio of these is determined to be:

$$T_1(0,\ t_a + t_d)/T_0(0, t_a + t_d) \approx 2e^{-1} = 0.735\cdots$$

From this it follows that at time $t = t_a + t_d$, $T_1(0, t)$ is not sufficiently small with respect to $T_0(0, t)$. As described above, however, the second- and higher-order components of $T(z, t)$ have already attenuated sufficiently at time $t = t_a + t_d$, and thus $T_1(0, t_a + t_d)$ is sufficiently small with respect to $T(0, t_a + t_d)$.

To make $T_1(0, t)$ sufficiently small with respect to $T_0(0, t)$, one needs more time. That is, as described by inequality (2), one needs, after the arbitrary round of irradiation is completed, to wait the waiting time $t_w$ equal to or longer than the predetermined time $t_d$.

For the sake of explanation, let $t_w$ be expressed by:

$$t_w = \gamma t_d \qquad (12)$$

Then at time $t = t_a + t_w$, $T_0(0, t)$ and $T_1(0, t)$ respectively become $T_0(0, t_a + t_w) = T_a h/L$ and $T_1(0, t_a + t_w) \approx (2T_a h/L)e^{-\gamma}$. The ratio of these is determined to be:

$$T_1(0,\ t_a + t_w)/T_0(0, t_a + t_w) \approx 2e^{-\gamma}$$

In equation (12), $\gamma$, which is equal to or greater than 1, represents a factor by which to extend $t_w$. This factor will hereinafter be referred to as the extension factor.

When $\gamma = 3$, the above ratio is determined to be:

$$T_1(0,\ t_a + t_w)/T_0(0, t_a + t_w) \approx 2e^{-3} = 0.0995\cdots \approx 0.1$$

That is, the ratio becomes sufficiently small. If $\gamma$ is increased to, for example, $\gamma = 5.3$ or 7.6, the ratio becomes about 0.01 or 0.001, respectively.

If the extension factor $\gamma$ is set to 3 or more, $|T_1(0, t)|$ becomes sufficiently small with respect to $|T_0(0, t)|$ at time $t = t_a + t_w$, as described above, and as a result, $T(z, t)$ approaches $a_0$ sufficiently. That is, the heat given to the heat generating part of the powder layer is thoroughly diffused toward a deeper part of the powder layer.

This assumes that the thickness of the powder layer consisting of the metal powder 104 is sufficiently large with respect to that of the heat generating part. This assumption holds for the operation of the three-dimensional shaping apparatus 100 as well as that of many of the other electron beam three-dimensional shaping apparatuses.

If the powder layer is not sufficiently thick, $T(z, t)$ sufficiently approaches $a_0$ before time $t = t_a + t_w$. This is because if the powder layer is not sufficiently thick, the coefficients of the first- and higher-order components of $T(z, t)$, that is, $a_k$ for $k \geq 1$, are small while the coefficient of the zeroth-order component $T_0(z, t)$, that is, $a_0$, is large. If the thickness of the powder layer is equal to that of the heat generating part, $T(z, t) = a_0$ regardless of the time $t$. If even in such cases $t_w$ is set to $\gamma t_d$, the result is that at $t = t_a + t_w$, $T(z, t)$ may be closer to the zeroth-order component $a_0$ but may never be farther away from it, and thus no problem is caused to the operation of the three-dimensional shaping apparatus 100.

To verify the effect of performing the multiple scanning and irradiation of the powder layer consisting of the metal powder 104 and of setting the waiting time $t_w$ to the predetermined time $t_d$ or longer, that is, the effect of the preventive measure against the excessive temperature rise of the powder layer, the temperature distribution of the powder layer irradiated with the electron beam 107 in the depth direction (Z direction) and the time transition of its temperature distribution were investigated by numerical thermal analysis for the different numbers of division N of the irradiation time and different waiting times $t_w$. The method and the results of the analyses, and discussion of the results will be described below.

The analyses were performed by composing, for the powder layer in which heat is generated, a one-dimensional thermal diffusion equation written by:

$$\frac{\partial T(z,t)}{\partial t} = \alpha \frac{\partial^1 T(z,t)}{\partial z^1} + \frac{1}{\rho c} Q(z,t) \qquad (13)$$

and solving it with a finite difference method. In equation (13), $T(z, t)$ represents the temperature [°C] of the powder layer at an arbitrary point in the small region 202. That is, $T(z, t)$ does not represent a temperature change of the powder layer due to an arbitrary round of irradiation, and thus does not become zero even without the arbitrary round of irradiation. $Q(z, t)$ represents the heat per unit volume [W/cm$^3$] at an arbitrary point in the small region 202, and takes a nonzero value while the point is irradiated with the electron beam 107, but is zero otherwise. These functions both assume the time $t$ to be zero at the time point where the first round of the total of N times of irradiation with the electron beam 107 starts. Here, N is 2 or greater as long as the small region 202 undergoes the multiple scanning and irradiation, but is 1 otherwise.

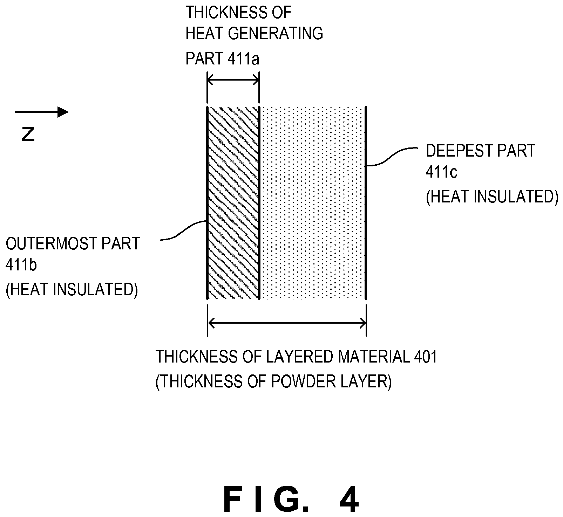

Fig. 4 shows a calculation model for the analysis. The model assumes the following conditions. First, the powder layer consisting of the metal powder 104 is a continuous layered material 401 regardless of the gaps between the particles of the metal powder 104, and the density, specific heat, and heat conductivity of the layered material 401 are uniform. These values are constant regardless of melting or solidification of the layered material 401.

Second, the heat in the heat generating part 411a of the layered material 401 is also uniform. The power given per unit area by scanning the layered material 401 to the layered material 401 is determined by simply dividing the power of the electron beam 107 by its cross-sectional area. Here, the power of the electron beam 107 is supplied to the heat generating part 411a without loss. The outer side of the heat generating part 411 a coincides with the outermost part 411b, and the thickness of the heat generating part 411a is smaller than that of the layered material 401.

Third, the layered material 401 is thermally continuous in the range from the outermost part 411b to the deepest part 411c and thus heat can be diffused in the range, but the layered material 401 is thermally insulated at the outermost part 411b and deepest part 411c and thus the heat is not diffused to above the outermost part 411b or to below the deepest part 411c. From this assumption, the boundary condition for the solutions of equation (13) is that the gradients of the solutions at the boundaries, that is, the temperature gradients $\partial T(0, t)/\partial z$ and $\partial T(L, t)/\partial z$, are zero.

Fourth, the temperature of the layered material 401 before irradiation with the electron beam 107 is uniform, and is equal to the preheating temperature of the metal powder 104. From this assumption, the initial ($t = 0$) condition for the solutions of equation (13) is that the solution at each depth position, that is, the temperature $T(z, 0)$, is equal to the preheating temperature of the metal powder 104.

Fifth, as long as the layered material 401 is continuously irradiated with the electron beam 107, the superficial part of the layered material 401 is continuously irradiated with the electron beam 107 regardless of the temperature rise. In reality, if the temperature of the superficial part of the powder layer consisting of the metal powder 104 rises and thus the outer side of the powder layer is evaporated, the outermost part of the powder layer shifts toward the deeper side. As a result, the powder layer is given, at each point of irradiation, a recess having a diameter almost equal to that of the electron beam 107.

To determine the right-hand side of equation (13), physical quantities of the electron beam 107 and metal powder 104 were set to be as follows.

The acceleration voltage of the electron beam 107 was set to 50 kV, and the current of the electron beam 107 was set to 0.10, 1.0, or 10 mA. The cross-sectional diameter of the electron beam 107 on the shaping plane 105 was set to 0.2 mm regardless of the current of the electron beam 107. From these values, the power of the electron beam 107 was determined to be 0.0050, 0.050, or 0.50 kW, and the power of the electron beam 107 per unit area was determined to be 0.016, 0.16, or 1.6 MW/cm$^2$.

The thickness of the layered material 401 was set to 50 $\mu$m, and the thickness of the heat generating part 411a (superficial part) of the layered material 401 was set to 10 $\mu$m. From the thickness of the heat generating part 411 a and the power per unit area, the heat per unit volume Q in the heat generating part 411a of the layered material 401 was determined to be 1.6 GW/cm$^3$.

The material for the layered material 401 was chosen to be titanium (Ti), and the heat conductivity $\lambda$, density $\rho$, and specific heat c of Ti was set to 0.17 W/(cm·K), 4.5 g/cm$^3$, and 0.52 J/(g·K), respectively. By introducing these physical properties into equation (5), the thermal diffusion coefficient $\alpha$ of Ti was determined to be 0.073 cm$^2$/s. By introducing this and the thickness of the layered material 401 into equation (4), the predetermined time $t_d$ was determined to be 35 $\mu$s. The melting point and melting heat of Ti were chosen to be 1,668°C and 0.30 kJ/g, respectively.

Added to the above explanations is that there actually are gaps between the particles of the metal powder 104, and the density $\rho$ of the powder layer consisting of the metal powder 104 decreases accordingly. In addition, the power given per unit area to the powder layer decreases by the energy of the electrons reflected by the powder layer, and thus the heat per unit volume Q decreases accordingly. The heat per unit volume Q can further decrease because of the gaps between the particles of the metal powder 104. This is because the gaps increase the amount of electrons which pass per unit area through the powder layer increases, and the power given per unit area to the powder layer decreases accordingly.

The preheating temperature and target temperature of the layered material 401 were set to 800°C and 1,768°C, respectively. From these temperatures and the above thickness and physical properties, it follows that the heat necessary per unit area to raise the temperature of the layered material 401 from the preheating temperature to the target temperature, the heat necessary per unit area to melt the layered material 401, and the sum of these heats are 11, 6.8, and 18 J/cm$^2$, respectively.

The target temperature is the sum of the melting point of Ti, 1,668°C, and a temperature margin of 100°C. By incorporating such a margin into the target temperature (or irradiation time $t_e$), one can cancel the above-mentioned heat shortage, that is, the heat shortage due to the decrease in the irradiation time $t_e$, which decrease is caused by the slow response of the main deflector 103 and main deflection controller 113. The above margin is effective also in cancelling heat shortages due to such errors as errors in the thickness of the powder layer consisting of the metal powder 104, errors in the measurements of the beam current, and errors of the measurements of the beam cross-sectional diameter, and, in addition, a heat shortage caused by the heat dissipation, which is due to the evaporation of the superficial part of the powder layer.

When solving equation (13) to obtain the temperature distribution of the layered material 401 and the time transition of its temperature distribution, one needs to consider the melting and solidification of the layered material 401. This is because the temperature of the layered material 401, as well as that of other materials that are melted or solidified, presents a nonlinear response with respect to the heat given to it. The nonlinearity of the response stems from the melting heat (or solidification heat) of the material.

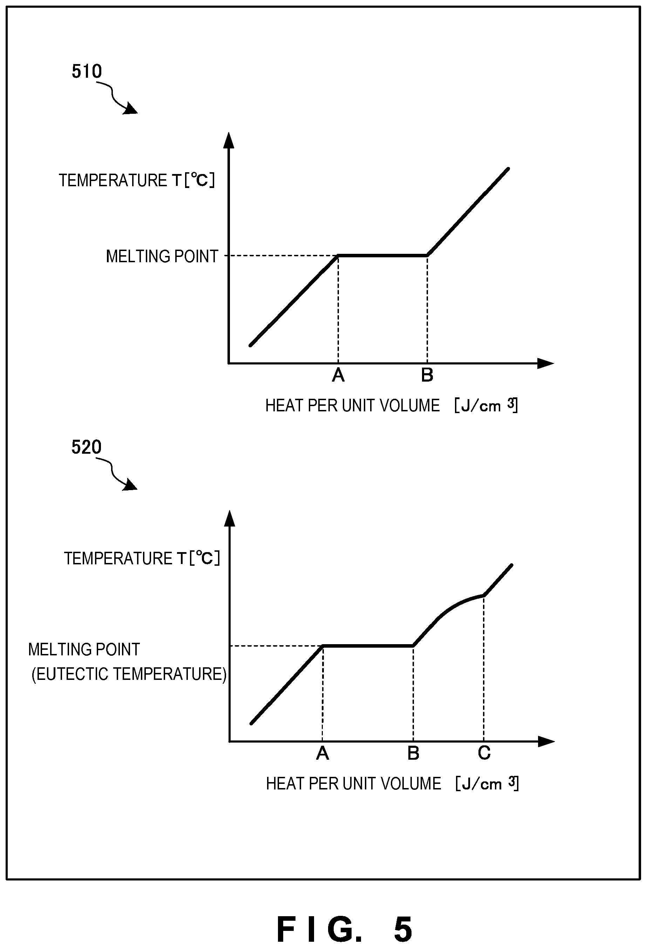

The above explanation is illustrated by Fig. 5. In Fig. 5, 510 is a graph showing the relationship between the temperature T [°C] at an arbitrary depth position of the layered material 401 and the heat per unit volume [J/cm$^3$] at the position. In 510, points A and B respectively represent the start and the end point of the melting of the layered material 401 at the position. As is apparent from 510, from point A to B the temperature T remains at the melting point regardless of the heat per unit volume. The width of the region is equal to the heat per unit volume necessary to melt the layered material 401, that is, the product of the melting heat [J/g] and the density [g/cm$^3$] of the layered material 401.

The characteristic that the temperature T remains at the melting point in the above region can be seen not only in pure metals (Ti in this embodiment) but also in alloys. A relationship similar to the above but with the layered material 401 being an alloy is shown in 520 of Fig. 5. The relationship, as opposed to that of when the layered material 401 is a pure metal, forms a curve in a region (from point B to C) on the right-hand side of point B, as shown in 520 of Fig. 5. This is a result of the layered material 401, as an alloy, allowing a solid and a liquid phase to coexist in the region.

The consideration of the melting and solidification, specifically, refers to providing the routine of solving equation (13) with a series of processes of evaluating the heat of the layered material 401 per unit volume, and modifying the temperature T(z, t) in accordance with the evaluation result. More specifically, the series of processes first determines the heat accumulated per unit volume in a microvolume at each depth position z at time t and, second, sets T(z, t) to that determined from equation (13) if the heat per unit volume is not in the range from point A to B, but resets T(z, t) to the melting point of the layered material 401 if the heat per unit volume is in the range from point A to B.

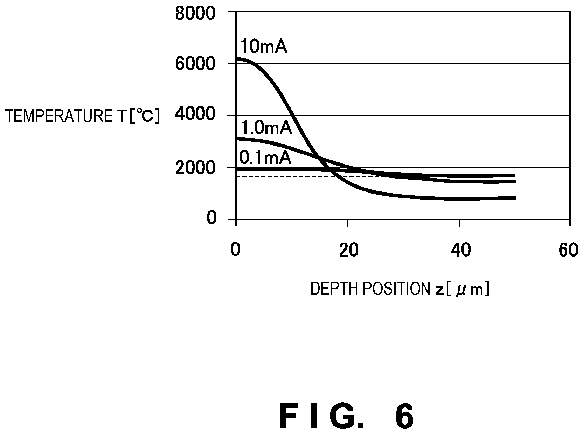

Under the above consideration, the temperature distribution of the layered material 401 in the depth direction (Z direction) was calculated by solving equation (13). For this, the number of division N of the irradiation time was set to 1 (not multiple irradiation) and the current of the electron beam 107 was set to 0.10, 1.0, or 10 mA. The results are shown in Fig. 6. The temperature distribution s shown in Fig. 6 are those at the completion of the irradiation operation with the electron beam 107. The broken line in Fig. 6 locates 1,668°C, that is, the melting point of the layered material 401 (Ti). Likewise the broken lines in similar figures below locate the melting point of the layered material 401 or other materials.

The heat given per unit area to the layered material 401 to obtain the above temperature distributions was, regardless of the current of the electron beam 107, set to 18 J/cm$^2$, that is, the above-mentioned summed heat per unit area. From the summed heat values per unit area for the above three current values, that is, 0.016, 0.16, and 1.6 MW/cm$^2$, the irradiation times $t_e$ for each point in the small region 202 for the three current values were respectively 1.1 ms, 0.11 ms, and 11 $\mu$s. That is, the irradiation time $t_e$ for each point is longer than the predetermined time $t_d$ (35 $\mu$s) if the current of the electron beam 107 is 0.10 or 1.0 mA, but is shorter than the predetermined time if the current is 10 mA. From these irradiation times $t_e$ and the cross-sectional diameter of the electron beam 107, that is, 0.2 mm, the scanning speeds determined for the three current values were 0.18, 1.8, and 18 m/s, respectively.

From Fig. 6, the temperature of the outermost part 411b at the completion of the irradiation with the electron beam 107 for its current of 0.10, 1.0, or 10 mA is about 2,000°C, 3,100°C, or 6,200°C, respectively. As just described, if the current of the electron beam 107 is 0.10 or 1.0 mA, that is, if the irradiation time $t_e$ (1.1 or 0.11 ms) for each point in the small region 202 is longer than the predetermined time $t_d$ (35 $\mu$s), the temperature of the outermost part 411b is relatively close to the melting point (1,668°C) of the layered material 401. However, if the current of the electron beam 107 is 10 mA, that is, if the irradiation time $t_e$ (11 $\mu$s) at each point is shorter than the predetermined time $t_d$, the temperature of the outermost part 411b is significantly higher than the melting point of the layered material 401. On the other hand, the temperature of the deepest part 411c at the same time point is, for the current of 0.10 mA, equal to the melting point of the layered material 401; for the current of 1.0 mA, slightly lower than the melting point; for the current of 10 mA, about 800°C, which hardly shows any increase from the preheating temperature (800°C) of the layered material 401.

The temperature of the outermost part 411b being very high but that of the deepest part 411c remaining low, as described above, for the current of the electron beam 107 of 10 mA means that at the completion of the irradiation operation of the layered material 401 with the electron beam 107, the heat given by the electron beam 107 to the superficial part (heat generating part 411a) of the layered material 401 is yet to be transferred to a deeper part of the layered material 401 sufficiently and remains in the superficial part and its vicinity of the layered material 401. Here, a deeper part of the layered material 401 is yet to absorb the melting heat, and therefore the heat remaining in the superficial part and its vicinity of the layered material 401 includes the heat that should finally be absorbed by a deeper part of the layered material 401 as the melting heat. That is, the temperature of the superficial part of the layered material 401 is high accordingly.

The temperature of the deepest part 411c at the completion of the irradiation with the electron beam 107 being equal to the melting point of the layered material 401, as described above, for the current of the electron beam 107 of 0.10 mA is due to the relationship shown in 510 of Fig. 5. That is, at that time point, the heat per unit volume at the deepest part 411c exists in the range from point A to B in 510 of Fig. 5, and thus the temperature of the deepest part 411c remains at the melting point of the layered material 401.

As can be seen in Fig. 6, the temperature of the layered material 401 irradiated with the electron beam 107 becomes highest or lowest in the outermost part 411b or the deepest part 411 c, respectively. This is because the temperature gradient $\partial T(z, t)/\partial z$ becomes zero in the outermost part 411b and deepest part 411c, and because the outer side of the heat generating part 411 a coincides with the outermost part 411b.

Therefore, the highest reached temperature of the layered material 401 is identical to that of the outermost part 411b and the completion of the melting of the layered material 401 is equivalent to the melting of the deepest part 411c. Here, the melting of the deepest part 411c corresponds to the heat per unit volume at it exceeding point B in 510 of Fig. 5.

For these reasons, further thermal analyses were executed over the period from when the irradiation of the layered material 401 starts to when the deepest part 411c is melted, that is, to when the heat per unit volume exceeds point B in 510 of Fig. 5. From these analyses, the highest reached temperature of the outermost part 411b during the above period was determined and, on the basis of the highest reached temperature, the shaping conditions were evaluated. That is, the suppression of the temperature rise of the layered material 401 was evaluated.

Note that further thermal analyses were executed solely for the case where the heat given per unit area to the layered material 401 is considered large enough. This is because if the heat given per unit area to the layered material 401 is small, the highest reached temperature of the layered material 401 does not matter. Specifically, the current of the electron beam 107 was set to the largest of the above three current values, that is, 10 mA, and the cross-sectional diameter of the electron beam 107 was set to 0.2 mm, as designated above.

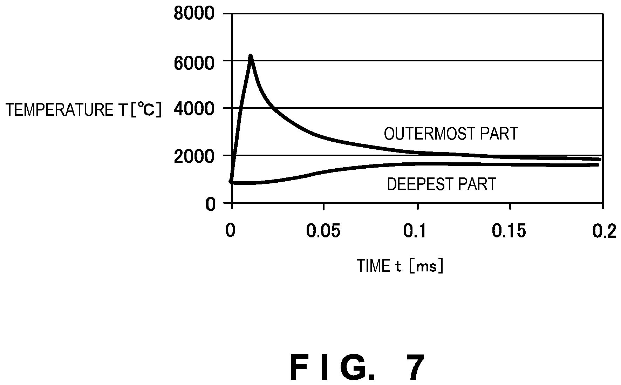

Fig. 7 shows the time transitions of the temperatures of the outermost part 411b and deepest part 411c obtained by setting the current and cross-sectional diameter of the electron beam 107 to the above values, and setting the number of division N of the irradiation time to 1 (not multiple irradiation). The peak value of the temperature of the outermost part 411b shown in Fig. 7 is equal to the above-described highest reached temperature, that is, about 6,200°C (Fig. 6). In other words, the highest reached temperature of the outermost part 411b is the temperature of the outermost part 411b at the completion of the irradiation with the electron beam 107.

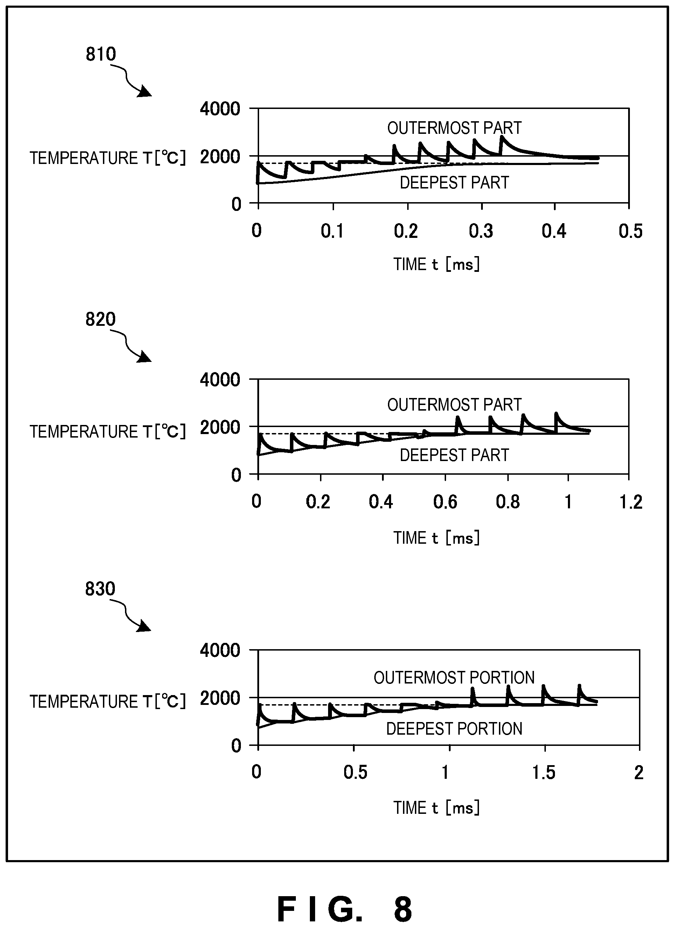

Fig. 8 shows the time transitions of the temperatures of the outermost part 411b and deepest part 411c obtained by setting the current and cross-sectional diameter of the electron beam 107 again to the above values, but setting the number of division N of the irradiation time to 10 (multiple irradiation). In Fig. 8, 810, 820, and 830 show the time transitions of the temperatures over the period from when the irradiation of the layered material 401 starts to when the deepest part 411c is melted, for N = 10 and the waiting time $t_w$ (= $\gamma t_d$) of 35 (= $t_d$), 105 (= $3t_d$), or 185 (= $5.3t_d$) $\mu$s, respectively. Here, the irradiation time per irradiation $t_e$/N and the speed of the scanning with the electron beam 107 are 1.1 $\mu$s and 0.18 km/s, respectively, regardless of the waiting time $t_w$.

The three waiting times $t_w$ correspond, from equation (12), to the extension factors of $\gamma$ = 1.0, 3.0, and 5.3, respectively. For these extension factors $\gamma$, the total number M of the points in the small region 202 are determined from equation (1) to be 32, 93, and 164, respectively. Note that here the speed of the scanning of the region which is included in the sub-deflection field 201 and where the metal powder 104 is not melted is considered sufficiently high and the distance of the scanning is considered sufficiently short, and thus the time $t_s$ taken to scan the region where the metal powder 104 is not melted is ignored.

Assuming that the area ratio of the small region 202, that is, the one-dimensional grid shown in Fig. 2 to the sub-deflection field 201 is 0.5, one can, from $\sqrt{(32/0.5)}$ = 8, $\sqrt{(93/0.5)}$ = 13.6..., or $\sqrt{(164/0.5)}$ = 18.1..., include the 32, 93, or 164 points in the sub-deflection field 201 by ensuring that the sub-deflection field 201 has a size that can include 64 (= $8^2$), 196 (= $14^2$), or 391 (= $19^2$) points in total, respectively. Assuming that the distance between two adjacent points in the small region 202 is equal to the cross-sectional diameter of the electron beam 107, that is, 0.2 mm, the above size is determined, from 0.2 x (8 - 1) = 1.4, 0.2 x (14 - 1) = 2.6, or 0.2 x (19 - 1) = 3.6, to be 1.4, 2.6, or 3.6 mm square or larger, respectively.

From Fig. 8 it follows that when the irradiation of the layered material 401 is multiple irradiation (N = 10), the highest reached temperature of the layered material 401 (the highest reached temperature of the outermost part 411b) is much lower than when the irradiation of the layered material 401 is not multiple irradiation (N = 1). More specifically, from 810 of Fig. 8 it follow that when the number of division N of the irradiation time is 10 and the waiting time $t_w$ is 35 $\mu$s (= $t_d$), the highest reached temperature of the layered material 401 is about 2,800°C. From 820 and 830 of Fig. 8, if follows that when N is 10 and $t_w$ is 105 (= $3t_d$) or 185 (= $5.3t_d$) $\mu$s, the highest reached temperature is even lower, that is, about 2,500°C. These temperatures are significantly lower than the highest reached temperature of about 6,200°C (Figs. 6 and 7), which is reached when N is 1.

These results support the appropriateness of setting the waiting time $t_w$ to $t_d$ or longer, and also the appropriateness of the above-described condition $\gamma \geq 3$ on the extension factor $\gamma$. Here, the highest reached temperature (Figs. 6 and 7) of when N is 1 can be interpreted as the highest reached temperature of when N is 10 but $t_w$ is zero, that is, $\gamma$ is zero. That is, the difference between the time transitions shown in Figs. 7 and 8 can be interpreted as the difference between whether $t_w$ is zero or is equal to $t_d$ or longer.

The highest reached temperature (about 2,500°C) of the layered material 401 of when the waiting time $t_w$ is 105 or 185 $\mu$s being lower than the highest reached temperature (about 2,800°C) of when $t_w$ is 35 $\mu$s, as described above, is because when $t_w$ is 105 or 185 $\mu$s, the heat given to the heat generating part (superficial part) of the layered material 401 is diffused toward a deeper part of the layered material 401 more thoroughly than when $t_w$ is 35 $\mu$s. This is found from the fact that, as shown in 820 and 830 of Fig. 8, when $t_w$ is 105 or 185 $\mu$s, the temperature of the outermost part 411b and that of the deepest part 411c come closer to each other with the lapse of the waiting time $t_w$ after any round of irradiation than when $t_w$ is 35 $\mu$s.

The highest reached temperature of the layered material 401 of when the waiting time $t_w$ is 105 or 185 $\mu$s is almost equal to the sum of the melting point of the layered material 401 and the maximum temperature rise per irradiation, as is found from 820 and 830 of Fig. 8. This is because the temperature of the outermost part 411b immediately before the start of the irradiation that raises the temperature to the highest reached temperature, that is, the Nth round of irradiation, is at or near the melting point of the layered material 401. Note that the maximum temperature rise per irradiation refers to a temperature rise in the region on the right-hand side of point B in Fig. 5, that is, a temperature rise which is not influenced by the nonlinearity of the temperature T.

The reasons why the temperature of the outermost part 411b immediately before the start of the Nth round of irradiation is at or near the melting point of the layered material 401 are as follows. First, as long as the waiting time $t_w$ satisfies inequality (2), the heat in the layered material 401 is sufficiently diffused in the depth direction (Z direction) during the waiting time $t_w$, and thus the temperature distribution of the layered material 401 is leveled. Second, the target temperature (1,768°C) of the layered material 401 is higher than the melting point (1,668°C) of the layered material 401, but the excess is as small as the above margin (100°C), and thus, when the temperature distribution becomes leveled, the temperature of the outermost part 411b cannot be significantly higher than the melting point of the material.

Note that in reality, even if the excess of the target temperature is large to some extent, the temperature of the outermost part 411b immediately before the start of the Nth round of irradiation cannot exceed the melting point of the layered material 401 significantly. This is because if the heat given per unit area to the layered material 401 becomes sufficient and the deepest part 411c is melted, that is, if the temperature of the deepest part 411c exceeds the melting point of the layered material 401, the deepest part 411c becomes thermally coupled to the powder layer or metal layer beneath it, and is thus cooled, and therefore the temperature rise of the outermost part 411b is suppressed.

The highest reached temperature (about 2,500°C) can be further lowered by increasing the number of division N of the irradiation time, which increase shortens the irradiation time per irradiation $t_e/N$. This is because if the irradiation time per irradiation $t_e/N$ is sufficiently shorter than the predetermined time $t_d$, the thermal diffusion in the layered material 401 during the irradiation time per irradiation $t_e/N$ can be ignored, and thus the temperature rise of the heat generating part of the layered material 401 can be considered proportional to the heat given per unit area to the layered material 401, that is, proportional to $t_e/N$.

However, if N is increased, one needs, because of the resulting shortening of $t_e/N$, to increase the speed of the scanning by the sub-deflector 108. Furthermore, one needs, in order to satisfy inequality (3), to increase the total number of points M in the sub-deflection field 201. That is, increasing N makes it necessary to increase the response speed of the sub-deflector 108 and sub-deflection controller 112, and simultaneously extend the sub-deflection field 201.

However, the response speed of the sub-deflector 108 and sub-deflection controller 112 cannot be increased unlimitedly. That is, the number of division N of the irradiation time is limited by the response speed of the sub-deflector 108 and sub-deflection controller 112. Furthermore, it is difficult to keep the response speed high and simultaneously increase the sub-deflection field 201. This is because the response speed and the size of the sub-deflection field 201 are given restrictions associated with electric circuits.

More specifically, extending the sub-deflection field 201 makes it necessary to increase the number of turns of the coils forming the sub-deflector 108, increase the current flowing through the coils, or take both these measures. However, increasing the number of turns of the coils delays the responses of the coils, and also makes it necessary to increase the rated voltage of the amplifiers used. That is, a difficulty arises of increasing both the rated voltage and the operating speed. Moreover, increasing the current flowing through the coils increases the heat generated by the amplifiers, and thus results in instability in the circuit operation. That is, a difficulty arises of increasing both the rated current and the current accuracy.

The reason why increasing the number of turns of the coils delays their responses, as described above, is that the increase in the number of turns increases the inductance of the coils, and thus decreases the resonance frequencies determined by the inductances, the parasitic capacitances (stray capacitance) of the coils, and the capacitances of the wiring. The reason why increasing the number of turns of the coils makes it necessary to increase the rated voltage of the amplifiers is that the voltages across the coils increase with the increase in the inductances.

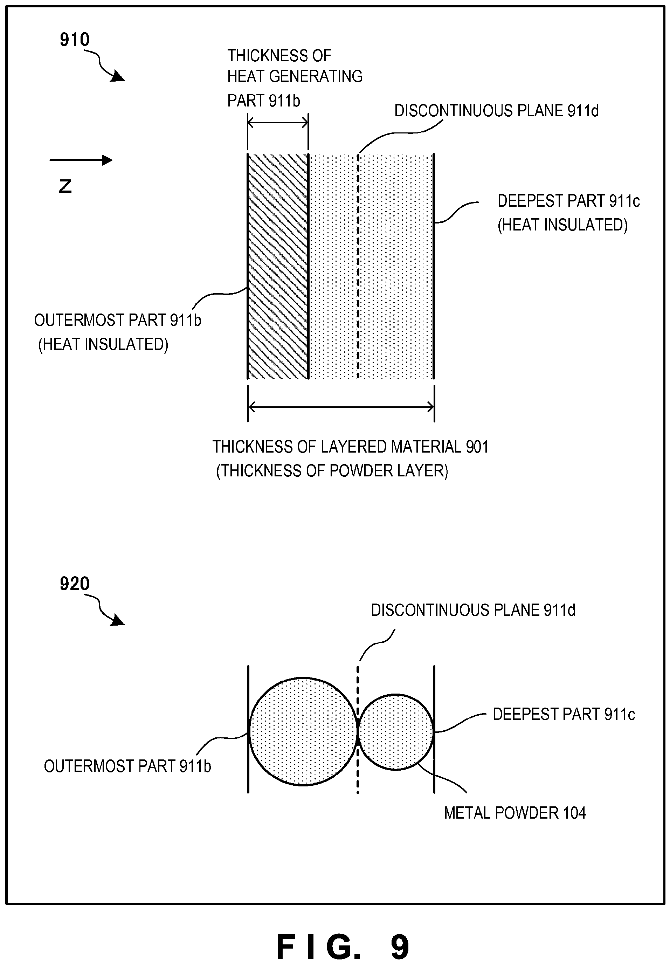

The above explanations assumed that the powder layer consisting of the metal powder 104 was a single continuous layered material 401, which was thermally insulated at the outermost part 411b and deepest part 411 c, and that the layered material 401 was thermally continuous in the range from the outermost part 411b to the deepest part 411c. In reality, however, a powder layer consisting of the metal powder 104 can have, in the range from the outermost to the deepest part, a thermally discontinuous plane. The reasons for this are as follows. First, as long as the particle size of the metal powder 104 is smaller than the thickness of the powder layer consisting of the metal powder 104, the thickness of the powder layer can contain a plurality of particles of the metal powder 104. Second, there are gaps between the plurality of particles of the metal powder 104. Third, the contact between particles of the metal powder 104 is a point contact, resulting in poor heat conduction. These explanations are illustrated by Fig. 9.

The particle size of the metal powder 104 is necessarily and obviously equal to or smaller than the thickness of the powder layer consisting of the metal powder 104. Moreover, the particle size of the metal powder 104 generally is not uniform and has a certain dispersion. For these reasons, the thickness of the powder layer can always contain a plurality of particles of the metal powder 104. That is, the metal powder 104 being spread over the shaping plane 105 is a result of relatively large powder particles forming gaps within the thickness of the powder layer consisting of the metal powder 104, and relatively small powder particles filling the gaps. Consequently, the powder layer has a discontinuous plane such as described above without exception. Note that the depth position of the discontinuous plane, that is, the depth position of one or some of the gaps depends on the size relationship between the plurality of particles, as is apparent from Fig. 9. That is, the depth position has a dispersion that stems from the dispersion in the particle size of the metal powder 104.

The discontinuous plane impedes the thermal diffusion from the superficial to a deeper part of the powder layer consisting of the metal powder 104. Therefore, the temperature distribution of the powder layer consisting of the metal powder 104 and the time transition of its temperature distribution may actually be different from those of the layered material 401.

To confirm this, numeric thermal analyses were executed for the layered material 401 having a discontinuous plane, that is, the layered material 901 shown in Fig. 9, and thus its temperature distribution in the depth direction (Z direction) and the time transition of the temperature distribution were investigated. Here, the discontinuous plane 911d was assumed to be perpendicular to the depth direction (Z direction), as shown in 910 of Fig. 9, and the layered material 901 was assumed to be thermally continuous in the range from the outermost part 911b to the discontinuous plane 911d and in the range from the discontinuous plane 911d to the deepest part 911c. Moreover, the discontinuous plane 911d was assumed to turn to a thermally continuous plane along with the melting of the layered material 901 in the range from the outermost part 911b to the discontinuous plane 911d.

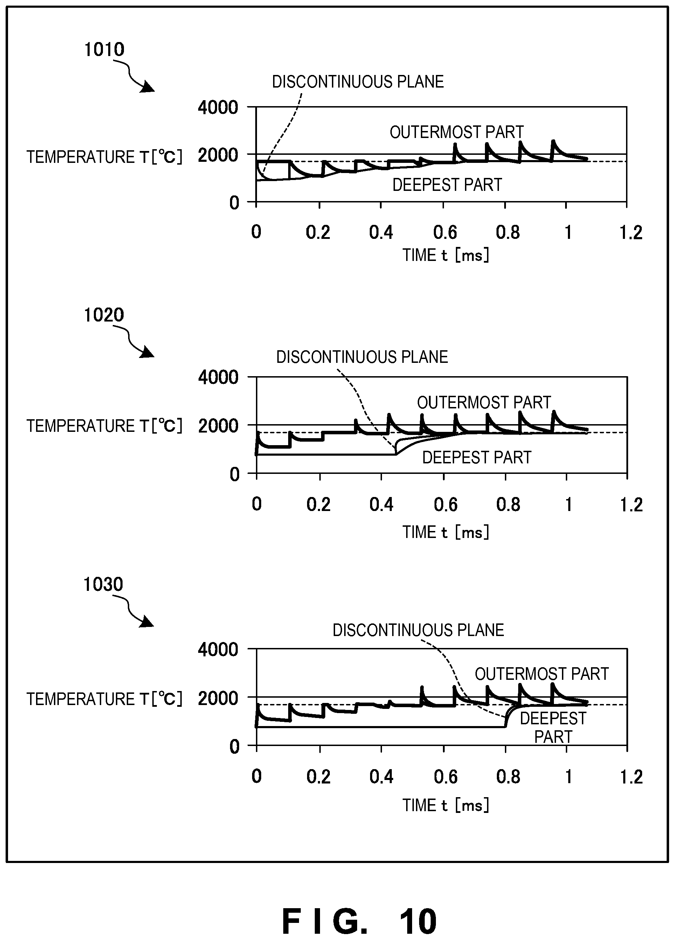

Fig. 10 shows results of the analyses for the layered material 901, which analyses were executed for the number of division N of the irradiation time of 10, and for the current and cross-sectional diameter of the electron beam 107 of 10 mA and 0.2 mm, respectively. In Fig. 10, 1010, 1020, and 1030 respectively show the time transitions of the temperatures of the outermost part 911b, discontinuous plane 911d, and deepest part 911c during the time period from when the irradiation of the layered material 901 starts to when the deepest part 911c is melted, which results were respectively obtained for L' = 5.25 or 40 $\mu$m. Here, L' represents the distance of the discontinuous plane 911d from the outermost part 911b. The temperature of the discontinuous plane 911d, which plane has two sides, that is, its outer and deeper sides, is more specifically the temperature of the deeper side of the discontinuous plane 911d.

From 1010 of Fig. 10 it follows that when L' = 5 $\mu$m, after the temperatures of the outermost part 911b and of the deeper side of the discontinuous plane 911d have been risen by the first round of irradiation to close to the melting point, the temperature of the discontinuous plane 911d decreases but the temperature of the outermost part 911b does not. This is because the discontinuous plane 911d impedes the thermal diffusion to the region ranging from it to the deeper side of the layered material 901. Then, after the second round of irradiation, these temperatures show almost the same transition. This is because somewhere in the period of the second round of irradiation, the layered material 901 become melted on the discontinuous plane 911d and thus the upper and the lower part of the layered material 901 become thermally coupled, and because both the discontinuous plane 911d and the outermost part 911b are included in the heat generating part of the layered material 901 and thus are given the same heat per unit volume.

From 1020 of Fig. 10 it follows that when L' = 25 $\mu$m, as compared with when L' = 5 $\mu$m or when the discontinuous plane 911d is absent, the timing at which the temperature of the outermost part 911b reaches close to the highest reached temperature is advanced, but the timing at which the temperature of the deepest part 911c starts to rise is delayed. This also is because the discontinuous plane 911d impedes the thermal diffusion. However, when L' = 25 $\mu$m, the discontinuous plane 911d is not included in the heat generating part of the layered material 901, and thus the temperature of the outermost part 911b and that of the discontinuous plane 911d show transitions different from each other.

From 1030 of Fig. 10 it follows that also when L' = 40 $\mu$m, as well as when L' = 25 $\mu$m, the timing at which the temperature of the outermost part 911b reaches close to the highest reached temperature is advanced, but the timing at which the temperature of the deepest part 911c starts to rise is delayed. This also is because the discontinuous plane 911d impedes the thermal diffusion. However, when L' = 40 $\mu$m, the position of the discontinuous plane 911d is deeper in the layered material 901, and thus the timing at which the temperature of the outermost part 911b reaches close to the highest reached temperature is not as much advanced as when L' = 25 $\mu$m. In contrast, the timing at which the temperature of the deepest part 911c starts to rise is delayed more than when L' = 25 $\mu$m.

Although because of the discontinuous plane 911 d the temperatures of the outermost part 911b and deepest part 911c show such transitions as described above, the layered material 901 is, as will be apparent from comparing 1010, 1020, and 1030 of Fig. 10 with 820 of Fig. 8, almost the same in the highest reached temperature as the layered material 401, despite the existence of the discontinuous plane 911d and regardless of its depth position. This is because the temperature rise of the heat generating part of the layered materials 401 and 901 per irradiation is determined, regardless of the presence or absence of the discontinuous plane 911d or its depth position, by the heat given per unit area to the layered material 401 or 901, and the temperature of the outermost part 411b or 911b immediately before the start of the irradiation which raises their temperature to the highest reached temperature is, regardless of the presence or absence of the discontinuous plane 911d or its depth position, close to the melting point of the layered material 401 or 901.

The reason why the temperature rise does not depend on the presence or absence of the discontinuous plane 911d or its depth position is that for an irradiation time per irradiation $t_e/N$ sufficiently shorter than the predetermined time $t_d$, the thermal diffusion in the layered material 401 or 901 during the irradiation time per irradiation $t_e/N$ can be ignored. That is, if the thermal diffusion can be ignored, whether or not the discontinuous plane 911d impedes the thermal diffusion does not influence the temperature rise of the heat generating part.

The reasons why the above temperatures (the temperatures of the outermost parts 411b and 911b) do not depend on the presence or absence of the discontinuous plane 911d or its depth position are as follows. First, while the layered material 901 is not melted at the discontinuous plane 911d, that is, while the discontinuous plane 911d has not turned to a thermally continuous plane, the waiting time $t_w$ satisfying inequality (2) ensures that the temperature distribution of the layered material 901 is leveled in the range from the outermost part 911b to the discontinuous plane 911d during the waiting time $t_w$, and thus the temperature of the outermost part 911 b immediately before the start of the irradiation which raises the temperature of the outermost part 911b to the highest reached temperature is close to the melting point of the layered material 901. Second, when the layered material 901 is melted at the discontinuous plane 911d and thus the discontinuous plane 911d has turned to a thermally continuous plane, the waiting time $t_w$ satisfying inequality (2) ensures that the temperature distribution of the layered material 901 is leveled in the range from the outermost part 911b to the deepest part 911c during the waiting time $t_w$, and thus the temperature distribution of the layered material 901 does not thereafter depend on the presence or absence of the discontinuous plane 911d. The first reason is based on the fact that $t_d'$ is determined by $L'^2/(\pi^2\alpha)$ ($< t_d = L^2/(\pi^2\alpha)$), according to equation (4), where $t_d'$ represents the waiting time for leveling the temperature distribution in the range from the outermost part 911b to the discontinuous plane 911d (length L' < L).

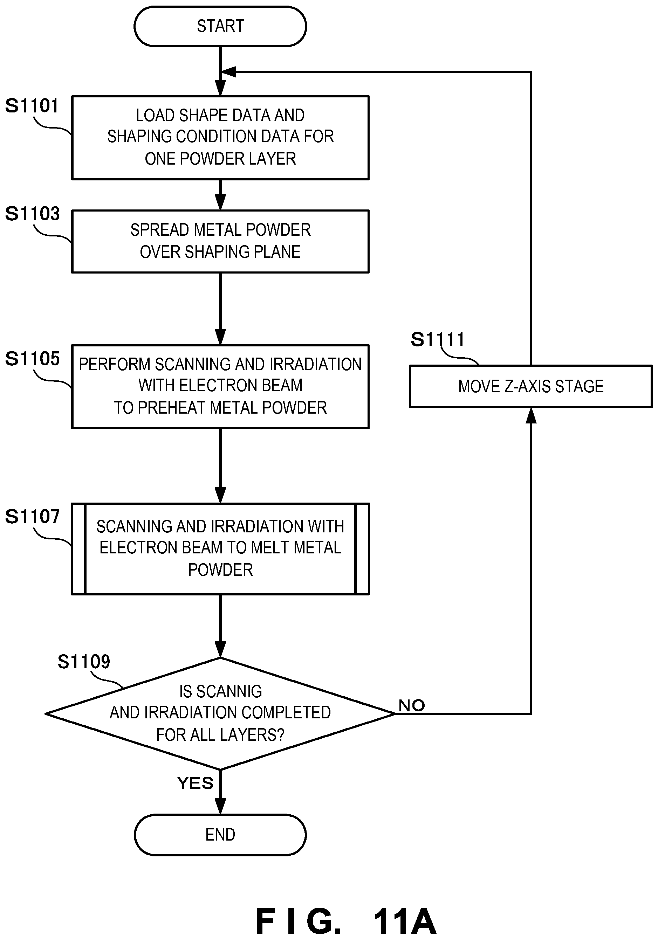

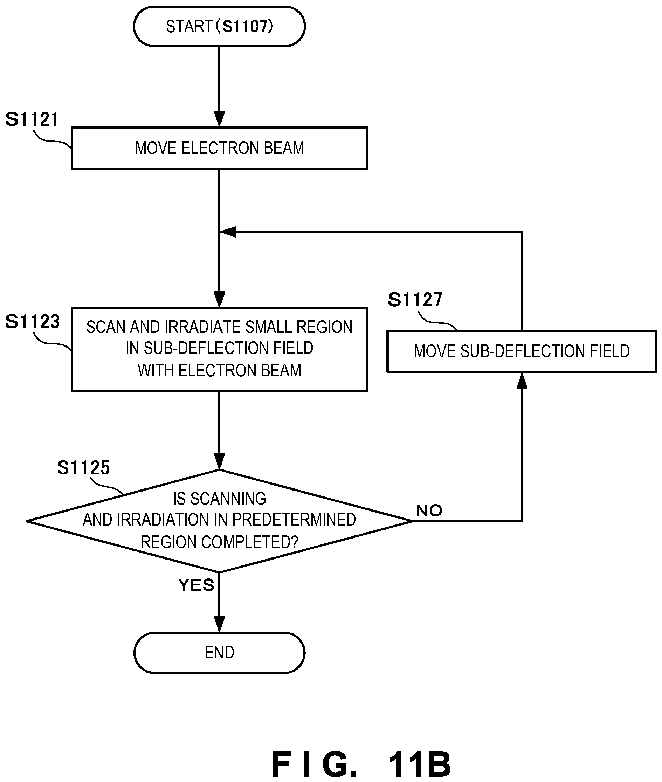

The procedure of shaping the three-dimensional structure by the three-dimensional shaping apparatus 100 will be described with reference to Figs. 11A and 11B. Fig. 11A is a flowchart explaining the procedure of shaping the three-dimensional structure by the three-dimensional shaping apparatus according to this embodiment.

In step S1101, the three-dimensional shaping apparatus 100 loads the shape data and shaping condition data for one powder layer. In step S1103, the three-dimensional shaping apparatus 100 spreads the metal powder 104 over the shaping plane 105, thereby forming the powder layer consisting of the metal powder 104. In step S1105, to preheat the metal powder 104 in a predetermined region (or the entire region) on the shaping plane 105, the three-dimensional shaping apparatus 100 scans and irradiates the region by causing the main deflector 103 to deflect the electron beam 107. In step S1107, to melt the metal powder 104 in the predetermined region, the three-dimensional shaping apparatus 100 scans and irradiates the predetermined region. In step S1109, the three-dimensional shaping apparatus 100 judges whether or not the scanning and irradiation has been completed for all layers. If the judgment is that the scanning and irradiation has been completed (YES in step S1109), the three-dimensional shaping apparatus 100 ends the shaping of the three-dimensional structure; otherwise (NO in step S1109), the three-dimensional shaping apparatus 100 advances to step S1111. In step S1111, the three-dimensional shaping apparatus 100 moves the Z-axis stage 106 by the thickness of the metal layer formed in the above steps. The three-dimensional shaping apparatus 100 repeats step S1101 and the subsequent steps.

Fig. 11B is a flowchart explaining the procedure of executing the scanning and irradiation with the electron beam in the procedure of shaping the three-dimensional structure with the three-dimensional shaping apparatus according to this embodiment. In step S1121, the three-dimensional shaping apparatus 100 moves the sub-deflection field 201 to a predetermined region on the shaping plane 105 by causing the main deflector 103 to deflect the electron beam 107. In step S1123, to melt the metal powder 104 in a small region 202 included in the sub-deflection field 201, the three-dimensional shaping apparatus 100 scans and irradiates the small region 202 by causing the sub-deflector 108 to deflect the electron beam 107. In step S1125, the three-dimensional shaping apparatus 100 judges whether or not the scanning and irradiation of the predetermined region has been completed. If the judgment is that the scanning and irradiation has been completed (YES in step S125), the three-dimensional shaping apparatus 100 ends the scanning and irradiation in the sub-deflection field 201; otherwise (NO in step S1125), the three-dimensional shaping apparatus 100 advances to step S1127. In step S1127, the three-dimensional shaping apparatus 100 moves the sub-deflection field 201 to a region which is included in the predetermined region and which includes another small region 202, by causing the main deflector 103 to deflect the electron beam 107. The three-dimensional shaping apparatus 100 repeats step S1123 and the subsequent steps.

As described above, according to this embodiment, one can increase the shaping speed by increasing the power of the electron beam 107, increase the shaping resolution by decreasing the cross-sectional diameter, or increase both, each of which increase results in increased power of the electron beam 107 per unit area, and can nonetheless prevent excessive evaporation of the powder layer consisting of the metal powder 104 without decreasing the shaping speed. By preventing the excessive evaporation, one can eventually prevent the resulting problems of excessive decrease in the thickness of the powder layer, and excessive contamination of the inside of the shaping apparatus 100 due to the evaporated metal film. Moreover, one can also prevent the heat to be given to the range from the outermost to the deepest part of the powder layer from being dissipated, and a deeper part of the powder layer from not melting.

[Second Embodiment]

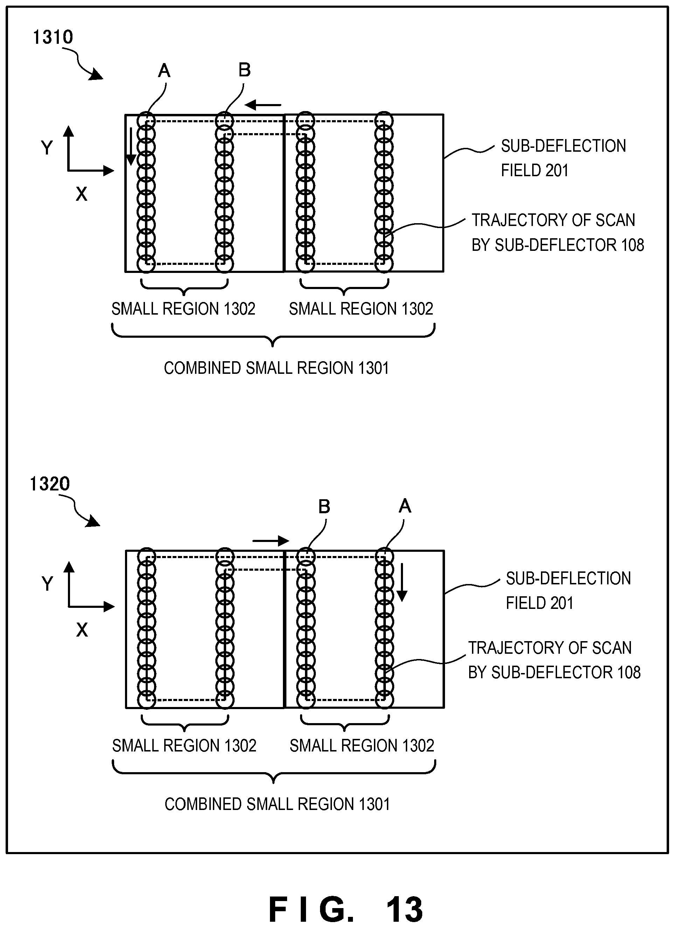

A three-dimensional shaping apparatus according to the second embodiment of the present invention will be described with reference to Figs. 13 to 15. The three-dimensional shaping apparatus 1300 according to this embodiment is different from the three-dimensional shaping apparatus 100 according to the first embodiment in that the former, unlike the latter, extends the region including points to be given multiple irradiation. Out of the components and operations of the three-dimensional shaping apparatus 1300, those common to it and the three-dimensional shaping apparatus 100 will respectively be given a common reference numeral, and a detailed description thereof will be omitted.

The three-dimensional shaping apparatus 1300 according to this embodiment has the same configuration as that of the three-dimensional shaping apparatus 100 according to the first embodiment.

The operation of the three-dimensional shaping apparatus 1300 is basically the same as that of the three-dimensional shaping apparatus 100. The three-dimensional shaping apparatus 1300, however, sets the region where the scanning and irradiation of M points in total are repeated N times in total, that is, the region including the M points in total each irradiated N times, to be larger than that set by the three-dimensional shaping apparatus 100. More specifically, the three-dimensional shaping apparatus 1300 assumes the above region to be a set of combined small regions which can each be included in the sub-deflection field 201. In contrast, the three-dimensional shaping apparatus 100 assumes the above region to be only one small region which can be included in the sub-deflection field 201.

Therefore, in this embodiment, M does not represent the total number of points irradiated in one small region but represents the total number of points irradiated in the set of the combined small regions and $t_s$ represents time taken to scan the regions which are included in the set of combined small regions and where metal powder 104 is not melted.

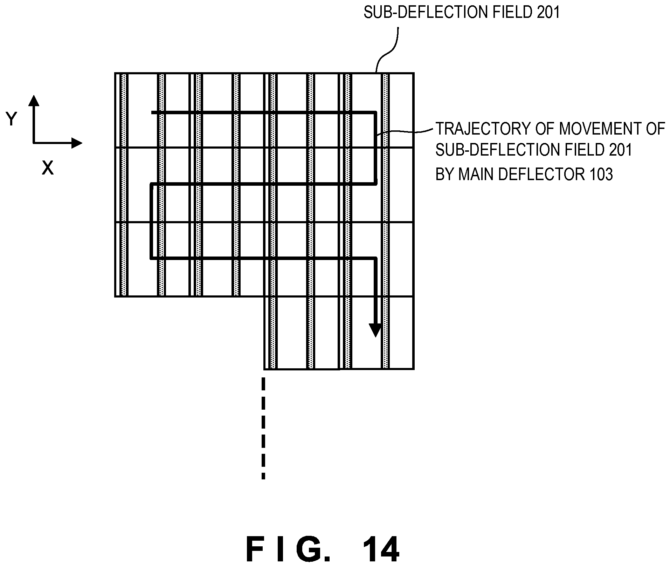

Fig. 13 shows how a set of combined small regions is scanned by the sub-deflector 108 in this embodiment, and Fig. 14 shows how sets of the combined small regions are reproduced and arranged on the shaping plane 105 in this embodiment. The set of the combined small regions 1301 shown in Fig. 13 is the same as each of the sets of the combined small regions in Fig. 14.

As shown in Fig. 13, the set of combined small regions 1301 is two small regions 1302 arranged side by side in the horizontal direction (the X direction). That is, the M points in total each irradiated N times are included in the set of combined small regions 1301. Examples of the scanning (per round) which can be repeated in the set of combined small regions 1301, include the two shown in Fig. 13. The reference symbols A and B in Fig. 13 denote the start and the end point of the scanning (per round), respectively.

The two small regions 1302 each form a one-dimensional grid, as with the small region 202 (Fig. 2). They are one of the segments of a one-dimensional grid larger than the sub-deflection field 201, which segments can each be included in the sub-deflection field 201. Note that the pitch of the one-dimensional grid is twice that in the first embodiment. Therefore, the total number of points in one small region 1302 is 1/2 the total number of points in one small region 202.

For the above reason, the total number of points in the set of combined small regions 1301, that is, the two small regions 1302, is equal to that in one small region 202. Therefore by, also in this embodiment, representing the total number of points in the set of combined small regions 1301 with M, as described above, and setting it to be equal to that in the first embodiment, one can ensure that the combination of M and N satisfies inequality (3).

Repeating the scanning and irradiation of the M points in total in the set of combined small regions 1301 makes it necessary to reciprocate the sub-deflection field 201 in the X direction between the two small regions 1302. In this embodiment, the reciprocation is performed by the main deflector 103. More specifically, the scanning and irradiation in this embodiment is as follows. First, the main deflector 103 moves the sub-deflection field 201 to the region which includes the small region 1302 to be scanned and irradiated. Second, half of the M points in total are scanned and irradiated. Third, the main deflector 103 moves the sub-deflection field 201 to the region which includes the other small region 1302, which is adjacent to the above small region 1302. Fourth, the other half of the M points are scanned and irradiated. This series of operations completes one round of the scanning and irradiation of the M points in total. Executing the same scanning and irradiation N times in total completes a total of N times of scanning and irradiation of the total of M points.

Repeating the above series of operations of causing the main deflector 103 to move the sub-deflection field 201 to a region which includes a new small region 1302 and executing N times of the scanning and irradiation of the M points in total reproduces and arranges sets of the combined small regions 1301 on the shaping plane 105. As a result, the one-dimensional grid shown in Fig. 14 is formed.

Added to the above explanations is that, strictly, at the time of the reciprocation the scanning and irradiation of the small region 1302 including point A is, as found from Fig. 13, not completed before the start of the scanning and irradiation of the small region 1302 not including point A. More specifically, the scanning and irradiation of the small region 1302 including point A ends temporarily with point B left, and point B is irradiated after the scanning and irradiation of the small region 1302 not including point A has ended. This is to prevent the trajectory of the scanning from point A to B from intersecting itself in the set of combined small regions 1301. If the trajectory intersects itself in the set of combined small regions 1301, the point which is included in the set of combined small regions 1301 and which is positioned at the intersecting point is given additional heat. The same applies to the small region 202 (Fig. 2).

Further added to the above explanations is that performing the above reciprocation with the main deflector 103 tends to bring about the above-mentioned problem of the shortage of heat, which shortage is caused by the slow response of the main deflector 103 and main deflection controller 113. This is because the total of N times of scanning and irradiating the total of M points in one small region 202 requires one to, for the scanning and irradiation of the grand total of M x N points, move the sub-deflection field 201 only once, but the total of N times of scanning and irradiating the total of M points in a set of combined small regions 1301, that is, the two small regions 1302, requires one to, for the scanning and irradiation of the same grand total of M x N points, move the sub-deflection field 201 2N times in total.

This problem can be mitigated if one, every time the total of M points are scanned and irradiated, changes the trajectory (Fig. 13) of the scanning from point A to B. More specifically, one should change the locations of the points scanned during the period from when the movement of the sub-deflection field 201 by the main deflector 103 starts to when it becomes stabilized. If the locations are fixed, the points at them suffer from an intense shortage of heat which may be difficult to overcome only with the above-described margin.

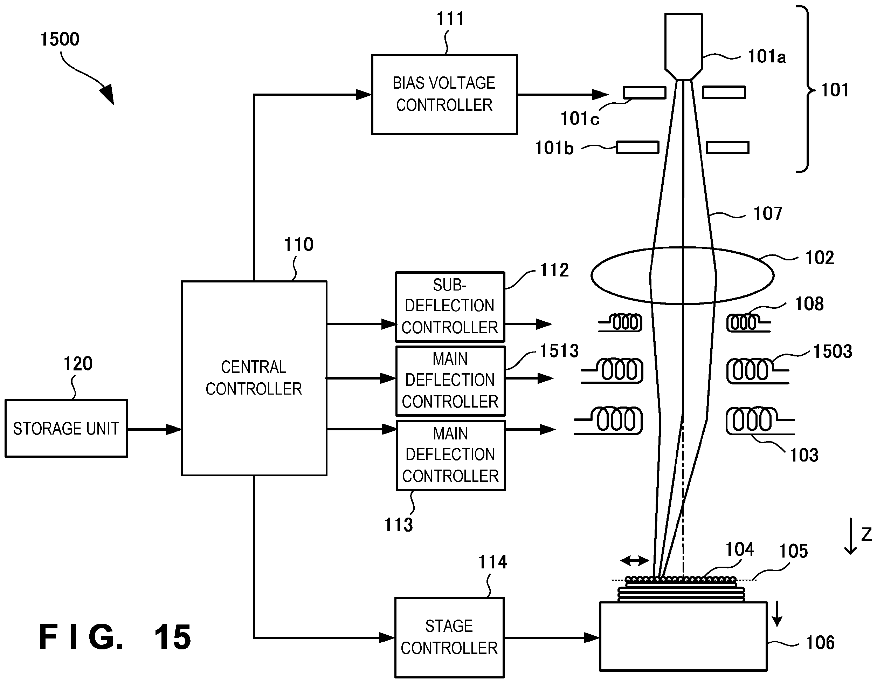

Another approach to the above problem is to provide, in addition to the main deflector 103 and the main deflection controller 113, a main deflector 1503 and a main deflector controller 1513 as shown in Fig. 15, so that the main deflector 1503 performs the above reciprocation. The main deflector 1503, controlled by the main deflector controller 1513, has a small deflection area but has a quick response, and thus is intended for quicker stabilization of the movement of the sub-deflection field 201.

As described above, according to this embodiment, inequality (3) can be satisfied even if the total number of points in the small region 202 which can be included in the sub-deflection field 201 is small. That is, even in such cases, excessive temperature rise of the metal powder 104 is prevented, and thus excessive evaporation of the metal powder 104 is prevented.

Added to the above explanations is that this embodiment assumes the set of combined small regions 1301, that is, the combined small regions 202 which can each be included in the sub-deflection field 201, to be the two small regions 1302 arranged in the horizontal direction (the X direction), but the two small regions 1302 can also be arranged in the vertical direction (Y direction). Furthermore, the number of small regions 1302 to be arranged in these manners may be three or more. The number may be fixed or variable as long as the combination of N and M satisfies inequality (3).

[Third Embodiment]

A three-dimensional shaping apparatus according to the third embodiment of the present invention will be described. The three-dimensional shaping apparatus according to this embodiment basically has the same configuration as that of the three-dimensional shaping apparatus 100 according to the first embodiment.

The operation in this embodiment is basically the same as that in the first or second embodiment. In this embodiment, however, multiple irradiation of the metal powder 104 is performed not only in a melting step but also in a preheating step. That is, both these steps use the main deflector 103 and the sub-deflector 108 for multiple scanning and irradiation of small regions 202 which can each be included in the sub-deflection field 201 or of combinations of them.

The preheating step, however, does not require such a high resolution as required in the melting steps, and allows the cross-sectional diameter of the electron beam 107 to be large accordingly. Increasing the cross-sectional diameter of the electron beam 107, decreases the power of the electron beam 107 per unit area accordingly, and thus increases the ease with which to suppress the highest reached temperature of the powder layer consisting of the metal powder 104.

Added to the above explanations is that if in the preheating step, as in the melting step, there is a discontinuous plane such as the discontinuous plane 911d (Fig. 9) in the range from the outermost to the deepest part of the powder layer, the discontinuous plane may impede thermal diffusion to the deeper side. However, during the course of the preheating or the melting step alike, the powder layer is melted in the range from the outermost part to the discontinuous plane, and thus the thermal diffusion progresses to the deeper side. That is, whether in the preheating or the melting step, the powder layer is eventually melted in the range from the outermost to the deepest part of the powder layer.

[Other Embodiments]

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

The present invention is applicable to a system including a plurality of devices or a single apparatus. The present invention is also applicable even when an information processing program for implementing the functions of the embodiments is supplied to the system or apparatus directly or from a remote site. Hence, the present invention also incorporates the program installed in a computer to implement the functions of the present invention by the computer, a medium storing the program, and a WWW (World Wide Web) server that causes a user to download the program. Especially, the present invention incorporates at least a non-transitory computer readable medium storing a program that causes a computer to execute processing steps included in the above-described embodiments.

**Claims**

1. A three-dimensional shaping apparatus comprising:

an electron gun that generates an electron beam;

a primary main deflector that deflects the electron beam one- or two-dimensionally;

at least one lens that is provided between said electron gun and said primary main deflector, and focuses the electron beam;

a sub-deflector that is provided between said electron gun and said primary main deflector, deflects the electron beam one- or two-dimensionally, and has a deflection area smaller than the deflection area of said primary main deflector and a scanning speed higher than the scanning speed of said primary main deflector; and

a controller that controls deflection directions and the scanning speeds of said primary main deflector and said sub-deflector,

wherein said primary main deflector moves the deflection area of said sub-deflector, and

said sub-deflector performs multiple scanning and irradiation of small regions, in which scanning and irradiation the small regions are each included in the deflection area and scanned and irradiated with the electron beam for a predetermined number of times.

2. The three-dimensional shaping apparatus according to claim 1, wherein said sub-deflector, after a predetermined waiting time after performing an arbitrary round of a predetermined number of times of scanning and irradiation of the small regions with the electron beam, performs the subsequent round of the predetermined number of times of scanning and irradiation of the small regions with the electron beam.

3. The three-dimensional shaping apparatus according to claim 2, wherein the predetermined waiting time is determined from $L^2/(\pi^2\alpha)$, where L is the thickness of the layer of the powder melted by the electron beam, $\alpha$ is the thermal diffusion coefficient of the layer of the powder, and $\pi$ is the circular constant.

4. The three-dimensional shaping apparatus according to claim 2, wherein the predetermined waiting time is determined from $\gamma L^2/(\pi^2\alpha)$ $(\gamma \geq 3)$, where L is the thickness of the layer of the powder melted by the electron beam, $\alpha$ is the thermal diffusion coefficient of the layer of the powder, and $\pi$ is the circular constant.

5. The three-dimensional shaping apparatus according to any one of claims 1 to 4, wherein during the predetermined waiting time said sub-deflector scans and irradiates regions other than the small regions with the electron beam.

6. The three-dimensional shaping apparatus according to any one of claims 1 to 5, wherein after the completion of the scanning and irradiation of the small region or regions currently scanned and irradiated with the electron beam, said primary main deflector moves the deflection area of said sub-deflector to a region which includes a small region or small regions other than the small region or regions currently scanned and irradiated with the electron beam.

7. The three-dimensional shaping apparatus according to any one of claims 1 to 5, wherein before the completion of the scanning and irradiation of the small region or regions currently scanned and irradiated with the electron beam, said primary main deflector moves the deflection area of said sub-deflector to a region which includes a small region or small regions other than the small region or regions currently scanned and irradiated with the electron beam.

8. The three-dimensional shaping apparatus according to any one of claims 1 to 5, further comprising:

a secondary main deflector between said primary main deflector and said sub-deflector,

wherein said controller further controls the direction and the scanning speed of the deflection by said second main deflector, and

said secondary main deflector has a deflection area smaller than the deflection area of said primary main deflector and a scanning speed higher than the scanning speed of said primary main deflector, and, before the completion of the scanning and irradiation of the small regions currently scanned and irradiated with the electron beam, moves the deflection area of said sub-deflector to a region which includes small regions other than the small regions currently scanned and irradiated with the electron beam.

9. The three-dimensional shaping apparatus according to any one of claims 1 to 8, wherein at the time of melting the powder, the heat given per unit area to the powder is set to be larger than the sum of the heat necessary per unit area for the temperature rise from the preheating temperature of the powder to the melting point of the powder and the heat necessary per unit area to melt the powder.

10. A control method of a three-dimensional shaping apparatus including

an electron gun that generates an electron beam;

a primary main deflector that deflects the electron beam one- or two-dimensionally;

at least one lens that is provided between the electron gun and the primary main deflector, and focuses the electron beam;

a sub-deflector that is provided between the electron gun and the primary main deflector, deflects the electron beam one- or two-dimensionally, and has a deflection area smaller than the deflection area of the primary main deflector and a scanning speed higher than the scanning speed of the primary main deflector; and

a controller that controls deflection directions and the scanning speeds of the primary main deflector and the sub-deflector,

the method comprising:

causing the primary main deflector to move the deflection area of the sub-deflector; and

causing the sub-deflector to perform multiple scanning and irradiation of small regions, in which scanning and irradiation the small regions are each included in the deflection area and scanned and irradiated with the electron beam for a predetermined number of times.

11. A control program of a three-dimensional shaping apparatus including:

an electron gun that generates an electron beam;

a primary main deflector that deflects the electron beam one- or two-dimensionally;

at least one lens that is provided between the electron gun and the primary main deflector, and focuses the electron beam;

a sub-deflector that is provided between the electron gun and the primary main deflector, deflects the electron beam one- or two-dimensionally, and has a deflection area smaller than the deflection area of the primary main deflector and a scanning speed higher than the scanning speed of the primary main deflector; and

a controller that controls deflection directions and the scanning speeds of the primary main deflector and the sub-deflector,

the program causing a computer to execute a method comprising:

causing the primary main deflector to move the deflection area of the sub-deflector; and

causing the sub-deflector to perform multiple scanning and irradiation of small regions, in which scanning and irradiation the small regions are each included in the deflection area and scanned and irradiated with the electron beam for a predetermined number of times.

**F I G. 1**

A   B

Y

X

203

203

SMALL REGION 202
(ONE-DIMENSIONAL GRID)

203

SUB-DEFLECTION FIELD 201

TRAJECTORY OF SCAN
BY SUB-DEFLECTOR 108

F I G.  2

SUB-DEFLECTION FIELD 201

TRAJECTORY OF MOVEMENT OF
SUB-DEFLECTION FIELD 201
BY MAIN DEFLECTOR 103

Y

X

# F I G. 3

THICKNESS OF
HEAT GENERATING
PART 411a

Z

DEEPEST PART
411c
(HEAT INSULATED)

OUTERMOST PART
411b
(HEAT INSULATED)

THICKNESS OF LAYERED MATERIAL 401
(THICKNESS OF POWDER LAYER)

# F I G.  4

510

TEMPERATURE T[℃]

MELTING POINT

A          B

HEAT PER UNIT VOLUME [J/cm³]

520

TEMPERATURE T[℃]

MELTING POINT
(EUTECTIC TEMPERATURE)

A          B          C

HEAT PER UNIT VOLUME [J/cm³]

# F I G. 5

F I G. 6

TEMPERATURE T[℃]

TIME t [ms]

F I G. 7

**FIG. 8**

910

THICKNESS OF
HEAT GENERATING
PART 911b

DISCONTINUOUS PLANE 911d

Z →

DEEPEST PART 911c
(HEAT INSULATED)

OUTERMOST PART 911b
(HEAT INSULATED)

THICKNESS OF LAYERED MATERIAL 901
(THICKNESS OF POWDER LAYER)

920

DISCONTINUOUS PLANE 911d

OUTERMOST PART 911b

DEEPEST PART 911c

METAL POWDER 104

# F I G.  9

**F I G. 10**

START

S1101 — LOAD SHAPE DATA AND SHAPING CONDITION DATA FOR ONE POWDER LAYER

S1103 — SPREAD METAL POWDER OVER SHAPING PLANE

S1105 — PERFORM SCANNING AND IRRADIATION WITH ELECTRON BEAM TO PREHEAT METAL POWDER

S1107 — SCANNING AND IRRADIATION WITH ELECTRON BEAM TO MELT METAL POWDER

S1109 — IS SCANNIG AND IRRADIATION COMPLETED FOR ALL LAYERS?

NO

S1111 — MOVE Z-AXIS STAGE

YES

END

F I G.  11A

START (S1107)

S1121 — MOVE ELECTRON BEAM

S1123 — SCAN AND IRRADIATE SMALL REGION
IN SUB-DEFLECTION FIELD
WITH ELECTRON BEAM

S1127 — MOVE SUB-DEFLECTION FIELD

S1125 — IS SCANNING
AND IRRADIATION IN PREDETERMINED
REGION COMPLETED?

NO

YES

END

**F I G.  11B**

1200

1211a

1201

1211c

1211b

1207

1202

1203

Z

1204 1205

1206

F I G. 12A

FIG. 12B

1310

A    B

Y

X

SUB-DEFLECTION
FIELD 201

TRAJECTORY OF SCAN
BY SUB-DEFLECTOR 108

SMALL REGION 1302    SMALL REGION 1302

COMBINED SMALL REGION 1301

1320

B    A

Y

X

SUB-DEFLECTION
FIELD 201

TRAJECTORY OF SCAN
BY SUB-DEFLECTOR 108

SMALL REGION 1302    SMALL REGION 1302

COMBINED SMALL REGION 1301

# F I G.   13

SUB-DEFLECTION FIELD 201

TRAJECTORY OF MOVEMENT OF
SUB-DEFLECTION FIELD 201
BY MAIN DEFLECTOR 103

Y

X

# F I G. 14

**F I G. 15**

EP 3 223 299 A1

<div align="center">

**INTERNATIONAL SEARCH REPORT**

</div>

| | International application No. |
|---|---|
| | PCT/JP2016/051656 |

**A. CLASSIFICATION OF SUBJECT MATTER**
*H01J37/30*(2006.01)i, *B22F3/105*(2006.01)i, *B22F3/16*(2006.01)i, *H01J37/305* (2006.01)i

According to International Patent Classification (IPC) or to both national classification and IPC

**B. FIELDS SEARCHED**

Minimum documentation searched (classification system followed by classification symbols)
H01J37/30, B22F3/105, B22F3/16, H01J37/305

Documentation searched other than minimum documentation to the extent that such documents are included in the fields searched
| | | | |
|---|---|---|---|
| Jitsuyo Shinan Koho | 1922–1996 | Jitsuyo Shinan Toroku Koho | 1996–2016 |
| Kokai Jitsuyo Shinan Koho | 1971–2016 | Toroku Jitsuyo Shinan Koho | 1994–2016 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br>A | US 2005/0186538 A1 (BEGO MEDICAL AG),<br>25 August 2005 (25.08.2005),<br>entire text; all drawings<br>& EP 1568472 A1 & DE 102004009127 A | 1–6,9–11<br>7–8 |
| Y<br>A | JP 10-32188 A (Toshiba Corp.),<br>03 February 1998 (03.02.1998),<br>entire text; all drawings<br>& US 5894057 A<br>entire text; all drawings | 1–6,9–11<br>7–8 |

☐ Further documents are listed in the continuation of Box C. ☐ See patent family annex.

| | |
|---|---|
| \* Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 25 February 2016 (25.02.16) | 08 March 2016 (08.03.16) |

| Name and mailing address of the ISA/<br>Japan Patent Office<br>3-4-3,Kasumigaseki,Chiyoda-ku,<br>Tokyo 100-8915,Japan | Authorized officer<br><br>Telephone No. |
|---|---|

Form PCT/ISA/210 (second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003531034 PCT